(19) Europäisches Patentamt
European Patent Office
Office européen des brevets

(11) **EP 4 450 988 A2**

(12) **EUROPEAN PATENT APPLICATION**

(43) Date of publication:
**23.10.2024 Bulletin 2024/43**

(21) Application number: **24160578.1**

(22) Date of filing: **29.02.2024**

(51) International Patent Classification (IPC):
**G01R 31/392** (2019.01)      **H01M 10/48** (2006.01)

(52) Cooperative Patent Classification (CPC):
**G01R 31/392; H01M 10/48;** H02J 7/005

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **17.04.2023 JP 2023067271**

(71) Applicant: **TOYOTA JIDOSHA KABUSHIKI KAISHA**
**Toyota-shi, Aichi-ken, 471-8571 (JP)**

(72) Inventors:
• **MATSUOKA, Shohei**
  **Toyota-shi, 471-8571 (JP)**
• **MARUYAMA, Yuko**
  **Toyota-shi, 471-8571 (JP)**
• **UCHIDA, Yoshihiro**
  **Toyota-shi, 471-8571 (JP)**
• **TSUJI, Koichi**
  **Toyota-shi, 471-8571 (JP)**
• **SUGO, Yuki**
  **Toyota-shi, 471-8571 (JP)**

(74) Representative: **D Young & Co LLP**
**3 Noble Street**
**London EC2V 7BQ (GB)**

(54) **BATTERY SYSTEM AND METHOD**

(57)      A battery system is configured to estimate a presence or absence of deterioration of a battery (20). This deterioration is a phenomenon in which an internal resistance of the secondary battery increases due to uneven ion concentration in a non-aqueous electrolyte. The battery system includes a voltage sensor (21) and an ECU (40). The voltage sensor (21) detects a voltage value (VV) of the battery (20). The ECU (40) is configured to perform a calculation process and an estimation process. The calculation process includes a process of calculating, in accordance with the voltage value (VV), an evaluation value for evaluating a degree of polarization mitigation after charging or discharging of the battery (20). The estimation process includes a process of estimating the presence or absence of the deterioration in accordance with the evaluation value.

FIG.2

EP 4 450 988 A2

**Description**

CROSS REFERENCE TO RELATED APPLICATIONS

This nonprovisional application is based on Japanese Patent Application No. 2023-067271 filed on April 17, 2023 with the Japan Patent Office, the entire contents of which are hereby incorporated by reference.

BACKGROUND

Field

The present disclosure relates to a battery system and a method, and particularly to a battery system and a method for estimating the presence or absence of deterioration of a secondary battery containing a non-aqueous electrolyte.

Description of the Background Art

There has been increasing attention given to secondary batteries having a non-aqueous electrolyte, such as lithium ion batteries. Frequent repetition of charging or discharging of such a secondary battery at a high rate (large current) results in uneven ion concentration in the non-aqueous electrolyte. As a result, the secondary battery increases in internal resistance and becomes deteriorated. Such deterioration of the secondary battery is also referred to as "high-rate deterioration."

Japanese Patent Laying-Open No. 2017-103080 discloses a battery system.
The battery system includes a secondary battery, a current sensor, and a control device. The current sensor detects a charging current or a discharging current of the secondary battery. The control device calculates, based on a detection value from the current sensor, an evaluation value for evaluating high-rate deterioration of the secondary battery. The control device determines whether or not an integrated value of the evaluation values is higher than a threshold value. When the integrated value is higher than the threshold value, the control device restricts charging power or discharging power of the battery in order to prevent excessive high-rate deterioration.

SUMMARY

According to the battery system described above, when the detection value from the current sensor includes a detection error, errors due to the detection errors may be accumulated in the integrated value. As a result, the errors accumulated in the integrated value may be increased to a non-negligible extent. In this case, the presence or absence of high-rate deterioration may not be appropriately estimated based on the integrated value (the charging power or the discharging power may not be restricted with appropriate timing).

The present disclosure has been made to solve the problem described above, and an object of the present disclosure is to provide a battery system and a method capable of appropriately estimating the presence or absence of deterioration of a secondary battery containing a non-aqueous electrolyte.

A battery system of the present disclosure is a battery system for estimating a presence or absence of deterioration of a secondary battery containing a non-aqueous electrolyte. This deterioration is a phenomenon in which an internal resistance of the secondary battery increases due to uneven ion concentration in the non-aqueous electrolyte. The battery system includes a voltage sensor and a processor. The voltage sensor detects a voltage value of the secondary battery. The processor is configured to perform a calculation process and an estimation process. The calculation process includes a process of calculating, in accordance with the voltage value, an evaluation value for evaluating a degree of polarization mitigation after charging or discharging of the secondary battery. The estimation process includes a process of estimating the presence or absence of the deterioration of the secondary battery in accordance with the evaluation value.

The foregoing and other objects, features, aspects and advantages of the present disclosure will become more apparent from the following detailed description of the present disclosure when taken in conjunction with the accompanying drawings.

BRIEF DESCRIPTION OF THE DRAWINGS

Fig. 1 schematically shows an overall configuration of a charging/discharging system including a vehicle having a battery system according to Embodiment 1 mounted thereon.

Fig. 2 shows hardware configurations of the vehicle and a power facility in detail.

Fig. 3 illustrates, by the presence or absence of high-rate deterioration, a transition of a voltage value after external charging of a battery is stopped.

Fig. 4 illustrates, by the presence or absence of high-rate deterioration, a transition of a voltage value VV after discharging of the battery is stopped.

Fig. 5 is a flowchart illustrating a process performed by an electronic control unit (ECU) in an embodiment.

Fig. 6 is a flowchart illustrating a procedure of a calculation process in Embodiment 1.

Fig. 7 is a flowchart illustrating a procedure of an estimation process in Embodiment 1.

Fig. 8 illustrates how an amount of polarization mitigation varies depending on the presence or absence of high-rate deterioration, when external charging is performed so as to increase a state of charge (SOC) from 10% to 30%.

Fig. 9 illustrates how the amount of polarization mitigation varies depending on the presence or absence of high-rate deterioration, when external charging is performed so as to increase the SOC from 50% to 70%.

Fig. 10 is a flowchart illustrating a process performed by the ECU in Modification 1.

Fig. 11 illustrates an exemplary evaluation value in Modification 2.

Fig. 12 illustrates another exemplary evaluation value in Modification 2.

Fig. 13 is a flowchart illustrating a procedure of the calculation process in Modification 2.

Fig. 14 is a flowchart illustrating a procedure of the estimation process in Modification 2.

Fig. 15 illustrates an exemplary evaluation value in Modification 3.

Fig. 16 illustrates another exemplary evaluation value in Modification 3.

Fig. 17 is a flowchart illustrating a process performed by the ECU in Modification 3.

Fig. 18 is a flowchart illustrating a procedure of the calculation process in Modification 3.

Fig. 19 is a flowchart illustrating a procedure of the estimation process in Modification 3.

Fig. 20 illustrates exemplary data for use in a normalization process in Embodiment 2.

Fig. 21 is a flowchart illustrating a process performed by the ECU in Embodiment 2.

Fig. 22 is a flowchart illustrating a procedure of the normalization process in detail.

Fig. 23 is a flowchart illustrating a procedure of a degree-of-progress calculation process in detail.

Fig. 24 illustrates exemplary data for use in the normalization process in a modification of Embodiment 2.

Fig. 25 illustrates the normalization process in the modification of Embodiment 2.

Fig. 26 is a flowchart illustrating a process performed by the ECU in the modification of Embodiment 2.

DESCRIPTION OF THE PREFERRED EMBODIMENTS

Embodiments of the present disclosure are hereinafter described in detail with reference to the drawings. The same or corresponding parts are denoted by the same reference characters in the drawings and description thereof will not be repeated. The respective embodiments and its modifications may be combined in any appropriate way.

[Embodiment 1]

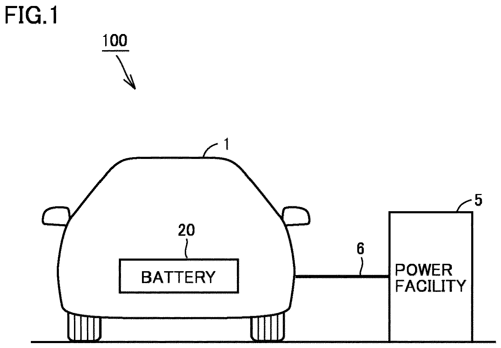

Fig. 1 schematically shows an overall configuration of a charging/discharging system including a vehicle having a battery system according to Embodiment 1 mounted thereon. Referring to Fig. 1, a charging/discharging system 100 includes a vehicle 1 and a power facility 5.

Vehicle 1 is an electric vehicle having a battery 20 mounted thereon, for example, a battery electric vehicle (BEV). Vehicle 1 may be any other type of electric vehicle, such as a plug-in hybrid electric vehicle (PHEV). Vehicle 1 is electrically connected to power facility 5 through a charging cable 6. Vehicle 1 is configured to perform external charging in which battery 20 is charged with electric power fed from a power facility external to vehicle 1, such as power facility 5. Vehicle 1 is also configured to perform external discharging in which electric power stored in battery 20 is discharged to power facility 5.

Power facility 5 is provided outside vehicle 1. Power facility 5 is a direct current (DC) charging facility configured to supply large-current feeding power to battery 20 through charging cable 6 during external charging. Large-current power is also supplied from battery 20 to power facility 5 during external discharging.

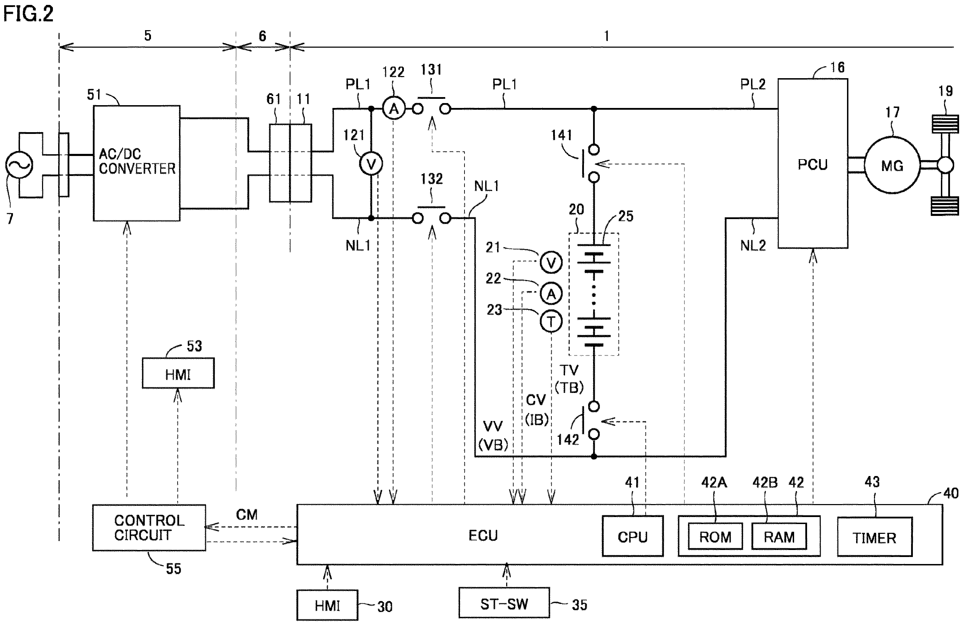

Fig. 2 shows hardware configurations of vehicle 1 and power facility 5 in detail. Referring to Fig. 2, power facility 5 includes an AC/DC converter 51, a human machine interface (HMI) device 53, and a control circuit 55.

AC/DC converter 51 converts AC power from a power grid (AC power supply) 7 into DC power. This DC power is used to charge battery 20. During external discharging, AC/DC converter 51 converts DC power from battery 20 into AC power, and supplies the AC power to power grid 7. HMI device 53 accepts various user operations from a user of vehicle 1. The user operations include an operation indicating a start of external charging of vehicle 1, and an operation of setting a charging-stopped SOC (target SOC) during external charging. Control circuit 55 determines a user operation, controls AC/DC converter 51, and exchanges various information with vehicle 1 through, for example, controller area network (CAN) communication.

Vehicle 1 includes an inlet 11, a voltage sensor 121, a current sensor 122, charging relays 131 and 132, a power control unit (PCU) 16, a motor generator 17, and a driving wheel 19. Vehicle 1 further includes battery 20, system main relays (SMRs) 141 and 142, a voltage sensor 21, a current sensor 22, and a temperature sensor 23. Vehicle 1 further includes an HMI device 30, a start switch (ST-SW) 35, and an ECU 40.

Inlet 11 is configured to connect with a charging connector 61 of charging cable 6. Voltage sensor 121 detects a DC voltage between a charging line PL1 and a charging line NL1. Current sensor 122 detects a current flowing through charging line PL1. Charging relay 131 is connected to charging line PL1. Charging relay 132 is connected to charging line NL1.

PCU 16 is electrically connected between power lines PL2, NL2 and motor generator 17. PCU 16 is configured to convert output power from battery 20 into AC power to thereby drive motor generator 17. PCU 16 can also convert AC power generated by motor generator 17 into DC power to charge battery 20.

Motor generator 17 is an AC rotating electric machine, for example, a permanent-magnet type synchronous motor that includes a rotor having a permanent magnet embedded therein. Output torque of motor generator 17 is transmitted to driving wheel 19. As a result, vehicle 1 runs. Motor generator 17 can also generate electric power with rotational force of driving wheel 19 during a braking operation of vehicle 1.

Battery 20 is a secondary battery containing a non-aqueous electrolyte, in this example a lithium ion battery having lithium ions as a reaction-participating material. A charged state of battery 20 is represented by an SOC. The SOC has a one-to-one correspondence with a voltage VB of battery 20. Battery 20 includes a plurality of cells 25. A negative electrode material of battery 20 includes graphite. Lithium is occluded between layers of a layered structure of the graphite. As a result, the graphite has a stage structure that regularly occludes lithium in each of its specific layers. The stage structure changes due to a change in the SOC.

Battery 20 stores electric power for generating driving force of vehicle 1. Battery 20 can also store electric power generated by motor generator 17. Battery 20 has a positive electrode electrically connected to charging line PL1 and power line PL2 through SMR 141. Battery 20 has a negative electrode electrically connected to charging line NL1 and power line NL2 through SMR 142.

Voltage sensor 21 detects a voltage value VV of battery 20, and provides voltage value VV to ECU 40. Voltage value VV is a detection value of voltage VB of battery 20. Current sensor 22 detects a current value CV of battery 20, and provides current value CV to ECU 40. Current value CV is a detection value of a current IB of battery 20. Current value CV is positive during discharging of battery 20 (when current IB is a discharging current of battery 20), and is negative during charging of battery 20 (when current IB is a charging current of battery 20). Temperature sensor 23 detects a temperature value TV of battery 20, and provides temperature value TV to ECU 40. Temperature value TV is a detection value of a temperature TB of battery 20.

HMI device 30 accepts various user operations. Start switch 35 accepts an operation indicating a start-up or shutdown of a travel system of vehicle 1. The start-up of the travel system corresponds to turning on of SMRs 141 and 142. The shutdown of the travel system corresponds to turning off of SMRs 141 and 142. After the shutdown of the travel system (turning off of SMRs 141 and 142), battery 20 is electrically disconnected from PCU 16, and charging or discharging of battery 20 is stopped.

ECU 40 includes a CPU 41, a memory 42, and a timer 43. CPU 41 performs various computation processes. Memory 42 includes a ROM 42A and a RAM 42B. ROM 42A stores a program for execution by CPU 41, and various data. Memory 42 may be included in vehicle 1 as a component external to ECU 40.

ECU 40 controls various devices of vehicle 1, such as charging relays 131 and 132, SMRs 141 and 142, PCU 16, and motor generator 17. ECU 40 controls PCU 16 to thereby control charging power and discharging power of battery 20 during travel of vehicle 1. ECU 40 can also restrict the charging power and the discharging power during travel (set a small upper limit value of the charging power and a small upper limit value of the discharging power). ECU 40 is configured to control turning on and off of charging relays 131 and 132, and turning on and off of SMRs 141 and 142. ECU 40 estimates the SOC of battery 20 based on voltage value VV, current value CV and temperature value TV. ECU 40 sequentially stores histories of voltage value VV and current value CV in memory 42.

ECU 40 can perform an external charging control process of controlling external charging. During this process, ECU 40 turns on charging relays 131 and 132 and SMRs 141 and 142, and exchanges various information with control circuit 55 through CAN communication. For example, ECU 40 receives, from control circuit 55, information indicating that a start of external charging has been indicated using HMI device 53. ECU 40 can also perform an external discharging control process of controlling external discharging.

During the external charging control process, ECU 40 transmits, to control circuit 55, a control command CM indicating power feeding from power facility 5 to inlet 11 (battery 20). ECU 40 performs the external charging control process through control command CM. The external charging control process includes a stop process of stopping external charging. The stop process is performed when the SOC of battery 20 reaches the charging-stopped SOC. The stop process is also performed when voltage value VV reaches a charging-completed voltage value of battery 20 which corresponds to the charging-stopped SOC. A target to be monitored for the stop process may be either the SOC or voltage value VV. The stop process corresponds, for example, to a process of transmitting control command CM indicating a stop of power feeding to power facility 5, and turning off charging relays 131 and 132 and SMRs 141 and 142. ECU 40 can also start external charging by transmitting control command CM indicating a start of power feeding to power facility 5.

Battery 20, voltage sensor 21, current sensor 22, temperature sensor 23, charging relays 131 and 132, SMRs 141 and 142, PCU 16, and ECU 40 form an example of "battery system" of the present disclosure.

Frequent repetition of charging or discharging of battery 20 at a high rate, for example, external charging of battery 20 with power facility 5 (DC charging facility), results in uneven ion concentration in the non-aqueous electrolyte of battery 20. As a result, battery 20 increases in internal resistance and becomes deteriorated. Such deterioration, that is, a phenomenon in which the internal resistance of battery 20 increases due to the uneven ion concentration in the non-aqueous electrolyte of battery 20, is also referred to as "high-rate deterioration" of battery 20. When the high-rate deterioration of battery 20 is present, it is preferable for ECU 40 to restrict charging power and discharging power during travel in order to prevent further progress of the high-rate deterioration. Restricting the charging power and the discharging power in such a manner with appropriate timing requires appropriately estimating the presence or absence of high-rate deterioration. Failure to appropriately estimate the presence or absence of high-rate deterioration and failure to restrict the charging power and the discharging power with appropriate timing may result in lithium deposition as well as local overcharging and overdischarging of battery 20.

One method for estimating the presence or absence of high-rate deterioration is to calculate an integrated value of detection values (current values CV) from current sensor 22, and estimate the presence or absence of high-rate deterioration based on this integrated value. In this method, due to a detection error included in each current value CV, detection errors of current values CV may be accumulated in the integrated value. This may result in reduced accuracy of a result of estimation of the presence or absence of high-rate deterioration. Another method is to estimate the presence or absence of high-rate deterioration based on detection values from multiple sensors of vehicle 1. In this method, due to a detection error included in the detection value from each sensor, an estimation result may be adversely affected by multiple detection errors. Still another method is to measure an impedance of battery 20, and estimate the presence or absence of high-rate deterioration in accordance with an increment of the measured impedance. Since the increase in impedance is related not only to the high-rate deterioration but also to wear deterioration of battery 20, it is difficult to accurately distinguish the high-rate deterioration from the wear deterioration in this method. As a result, the presence or absence of high-rate deterioration may not be accurately estimated. Thus, these methods may have reduced accuracy of estimation of the presence or absence of high-rate deterioration.

The inventors noted that the presence or absence of high-rate deterioration is reflected in a degree of polarization mitigation of battery 20, specifically, that voltage VB at the time of polarization elimination behaves differently when the high-rate deterioration is present. The polarization is a phenomenon in which an electromotive force in the opposite direction to a current is temporarily generated after the current flows through battery 20. In other words, the polarization is a phenomenon in which voltage VB temporarily increases after charging of battery 20, or voltage VB temporarily decreases after discharging of battery 20. The polarization is eliminated (the electromotive force described above becomes zero, and voltage VB stabilizes) after a sufficiently long period has elapsed since the charging or the discharging. A method for estimating the presence or absence of high-rate deterioration in Embodiment 1 is described below.

ECU 40 performs a calculation process and an estimation process in order to estimate the presence or absence of high-rate deterioration. The calculation process corresponds to a process of calculating, in accordance with voltage value VV, an evaluation value for evaluating the degree of polarization mitigation after charging or discharging of battery 20. The estimation process corresponds to a process of estimating the presence or absence of high-rate deterioration in accordance with the evaluation value.

According to such a configuration, a result of the estimation of the presence or absence of high-rate deterioration is determined in accordance with the evaluation value (degree of polarization mitigation). The degree of polarization mitigation is readily calculated in accordance with voltage value VV. Thus, estimating the presence or absence of high-rate deterioration does not necessarily require the integrated value of detection values (current values CV) from current sensor 22, and detection values from other multiple sensors. This avoids the estimation result from being affected by detection errors of multiple detection values. Therefore, the presence or absence of high-rate deterioration can be appropriately estimated.

In this Embodiment 1, the evaluation value is the magnitude of a difference value between voltage value VV when charging or discharging of battery 20 is stopped, and voltage value VV at the time of polarization elimination of the secondary battery after the charging or the discharging is stopped. In this case, the estimation process includes a process of estimating that the high-rate deterioration is absent when the magnitude of the difference value is less than a predetermined first threshold value, and a process of estimating that the high-rate deterioration is present when the magnitude of the difference value is greater than or equal to the first threshold value. This is described in detail below.

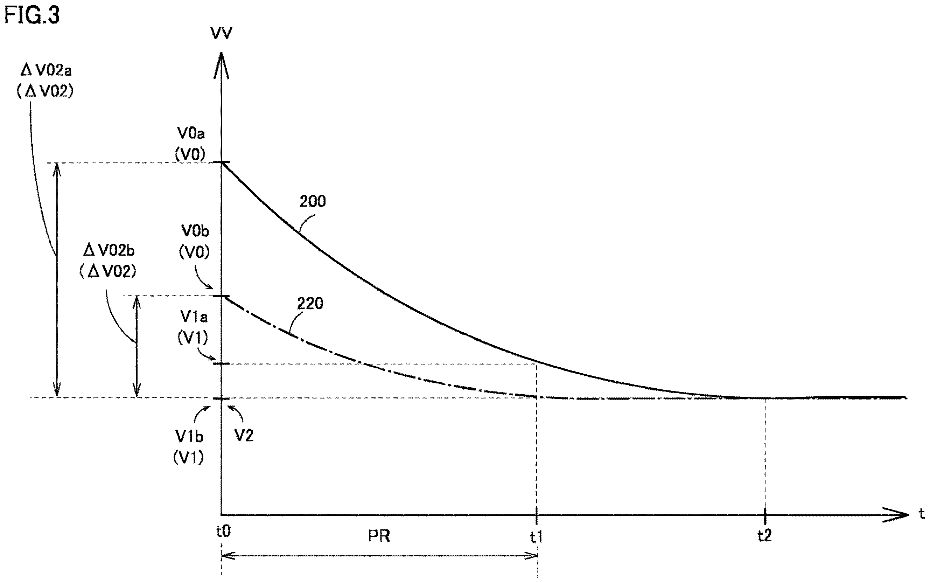

Fig. 3 illustrates, by the presence or absence of high-rate deterioration, a transition of voltage value VV (voltage VB) after external charging of battery 20 is stopped. Referring to Fig. 3, lines 200 and 220 represent transitions of voltage value VV in cases A and B, respectively. In this example, the high-rate deterioration is present in case A, and the high-rate deterioration is absent in case B.

At time t0, external charging is stopped. Voltage value VV at time t0 is also represented as V0. Note that V0 in cases A and B is also represented as V0a and V0b, respectively (VOa > V0b). In both cases A and B, polarization mitigation (decrease in voltage value VV) starts after time t0 (lines 200 and 220). Note that V0 varies depending on the charging-stopped SOC, and temperature TB and current IB during charging. Temperature TB during charging refers, for example, to temperature TB immediately after charging. Current IB during charging refers, for example, to an average value of current IB during charging.

At time t1, a predetermined period PR (e.g., one hour) has elapsed since time t0. Voltage value VV at time t1 is also represented as V1. Note that V0 in cases A and B is also represented as V1a and V1b, respectively. In case A, the polarization mitigation has not yet been completed and is continuing. In case B, on the other hand, the polarization has already been eliminated (the polarization mitigation has been completed). Voltage value VV at the time of polarization elimination after the charging or the discharging is stopped is represented as V2. In this example, V1b is equal to V2.

Time t2 is a time after time 11. In both cases A and B, at time t2, the polarization has been eliminated because voltage value VV is equal to V2. Note that V2 is determined depending on temperature TB. A period until the polarization is eliminated in case A (the length of a time period between time t0 and time t2) is longer than a period until the polarization is eliminated in case B (the length of a time period between time t0 and time 11). This means that the polarization mitigation takes a longer time when the high-rate deterioration is present.

In this example, an evaluation value EVV is a difference value (specifically, its magnitude) $\Delta V02$ between voltage value V0 and voltage value V2. Difference values $\Delta V02$ in cases A and B are also represented as $\Delta V02a$ and $\Delta V02b$, respectively ($\Delta V02a > \Delta V02b$). Note that $\Delta V02a$ and $\Delta V02b$ correspond to amounts of polarization mitigation in cases A and B, respectively. The amount of polarization mitigation in case A is greater than the amount of polarization mitigation in case B. Thus, the presence or absence of high-rate deterioration is reflected in the amount of polarization mitigation (difference value $\Delta V02$).

ECU 40 determines the elimination of the polarization based on the fact that voltage value VV stops decreasing (that voltage value VV becomes constant). In case A, ECU 40 determines that the polarization has been eliminated at time t2, and calculates $\Delta V02a$. In this example, since $\Delta V02a$ is greater than or equal to the predetermined first threshold value, ECU 40 estimates that the high-rate deterioration is present. In case B, ECU 40 determines that the polarization has been eliminated at time t1, and calculates $\Delta V02b$. In this example, since $\Delta V02b$ is less than the first threshold value, ECU 40 estimates that the high-rate deterioration is absent.

Errors included in difference value $\Delta V02$ are basically just detection errors of voltage sensor 21 (specifically, detection errors in V0 and V2), and are not affected by errors of other multiple sensors. In Embodiment 1, evaluation value EVV is calculated as difference value $\Delta V02$, and is thus unlikely to be affected by detection errors other than the detection errors of voltage sensor 21. As a result, the presence or absence of high-rate deterioration can be accurately estimated in accordance with difference value $\Delta V02$.

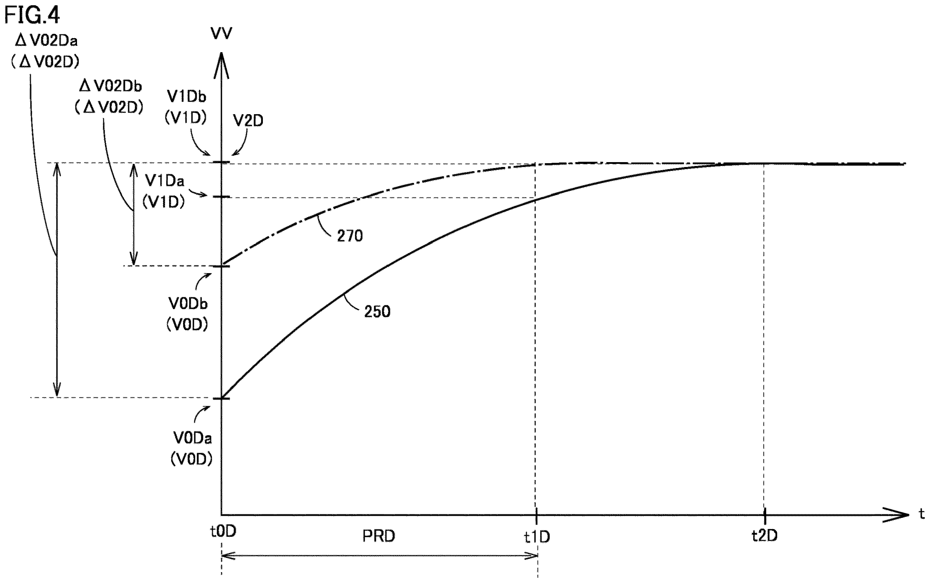

Fig. 4 illustrates, by the presence or absence of high-rate deterioration, a transition of voltage value VV (voltage VB) after discharging of battery 20 is stopped. Referring to Fig. 4, lines 250 and 270 represent transitions of voltage value VV in cases A and B, respectively.

At time t0D, the travel system is stopped due to a user operation on start switch 35, and discharging is stopped. Voltage value VV at time t0D is also represented as V0D. Note that V0D in cases A and B is also represented as V0Da and V0Db, respectively. (V0Da < V0Db). In both cases A and B, after time t0D, polarization mitigation (increase in voltage value VV) starts (lines 250 and 270). Voltage V0D varies depending on a discharging-stopped SOC, and temperature TB and current IB during discharging. Temperature TB during discharging refers, for example, to temperature TB immediately after discharging. Current IB during discharging refers, for example, to an average value of current IB during discharging. The discharging-stopped SOC corresponds to an SOC when the travel system is off.

At time t1D, a predetermined period PRD has elapsed since time t0D. Voltage value VV at time t1D is also represented as V1D. Note that V1D in cases A and B is also represented as V1Da and V1Db, respectively. In case A, the polarization mitigation has not yet been completed and is continuing. In case B, on the other hand, the polarization has already been eliminated. Voltage value VV at the time of polarization elimination after the charging or the discharging is stopped is represented as V2D. In this example, VIDb is equal to V2D.

Time t2D is a time after time t1D. In both cases A and B, at time t2D, the polarization has been eliminated because voltage value VV is equal to V2D. Note that V2D is determined depending on temperature TB.

In this example, evaluation value EVV is a difference value (specifically, its magnitude) $\Delta V02D$ between V0D and V2D. Difference values $\Delta V02D$ (amounts of polarization mitigation) in cases A and B are also represented as $\Delta V02Da$ and $\Delta V02Db$, respectively ($\Delta V02Da > \Delta V02Db$).

ECU 40 determines the elimination of the polarization based on the fact that voltage value VV stops increasing.

In case A, ECU 40 determines that the polarization has been eliminated at time t2D, and calculates ΔV02Da. In this example, since ΔV02Da is greater than or equal to the first threshold value, ECU 40 estimates that the high-rate deterioration is present. In case B, ECU 40 determines that the polarization has been eliminated at time t1D, and calculates ΔV02Db. In this example, since ΔV02Db is less than the first threshold value, ECU 40 estimates that the high-rate deterioration is absent.

Errors included in difference value ΔV02D are also unlikely to be affected by detection errors other than the detection errors of voltage sensor 21 (specifically, detection errors in V0D and V2D). As a result, the presence or absence of high-rate deterioration can be accurately estimated in accordance with difference value ΔV02D.

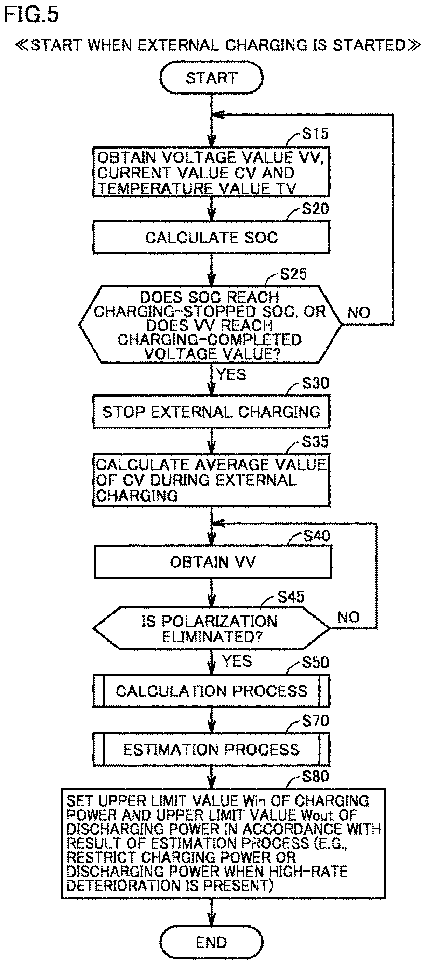

Fig. 5 is a flowchart illustrating a process performed by ECU 40 in an embodiment. This flowchart starts when ECU 40 receives, from control circuit 55, information indicating that a start of external charging has been indicated. In the following description, each step will be abbreviated as "S".

Referring to Fig. 5, ECU 40 obtains voltage value VV, current value CV and temperature value TV from voltage sensor 21, current sensor 22 and temperature sensor 23, respectively (S15). ECU 40 calculates an SOC in accordance with voltage value VV, current value CV and temperature value TV (S20). ECU 40 calculates, for example, an SOC during external charging (charging-started SOC).

ECU 40 determines whether or not the SOC has reached the charging-stopped SOC, or voltage value VV has reached the charging-completed voltage value corresponding to the charging-stopped SOC (S25). This charging-completed voltage value is stored in memory 42. When the SOC has not reached the charging-stopped SOC, or voltage value VV has not reached the charging-completed voltage value (NO in S25), the process returns to S15. When the SOC reaches the charging-stopped SOC, or voltage value VV reaches the charging-completed voltage value (YES in S25), the process proceeds to S30.

ECU 40 stops the external charging (S30). ECU 40 stores voltage value VV when the external charging is stopped (V0) in memory 42. ECU 40 calculates an average value of current value CV during the external charging (S35), and stores this average value in memory 42.

ECU 40 obtains voltage value VV (S40). ECU 40 determines whether or not the polarization has been eliminated in accordance with voltage value VV (S45). When the polarization has not yet been eliminated (NO in S45), the process returns to S40. When the polarization has been eliminated (YES in S45), ECU 40 performs the calculation process and the estimation process described above (S50 and S70).

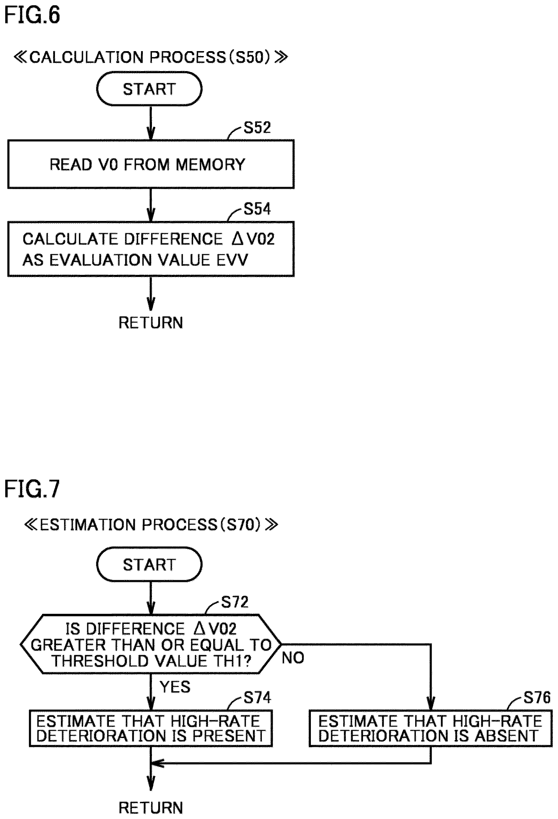

Fig. 6 is a flowchart illustrating a procedure of the calculation process (S50) in Embodiment 1. Referring to Fig. 6, ECU 40 reads voltage value VV when the external charging is stopped (V0) from memory 42 (S52). ECU 40 calculates difference ΔV02 as evaluation value EVV (S54). The process then returns to the process of Fig. 5, and proceeds to S70.

Fig. 7 is a flowchart illustrating a procedure of the estimation process (S70) in Embodiment 1. Referring to Fig. 7, ECU 40 determines whether or not difference ΔV02 is greater than or equal to a threshold value TH1 (which corresponds to the first threshold value described above) (S72). When difference ΔV02 is greater than or equal to threshold value TH1 (YES in S72), ECU 40 estimates that the high-rate deterioration is present (S74). When difference ΔV02 is less than threshold value TH1 (NO in S72), ECU 40 estimates that the high-rate deterioration is absent (S76). The process then returns to the process of Fig. 5, and proceeds to S80.

Referring again to Fig. 5, ECU 40 sets an upper limit value Win of charging power and an upper limit value Wout of discharging power in accordance with a result of the estimation process (S80). When it is estimated that the high-rate deterioration is absent in S76, for example, ECU 40 sets upper limit value Win to its default value, and sets upper limit value Wout to its default value. When it is estimated that the high-rate deterioration is present in S74, on the other hand, ECU 40 sets upper limit value Win to a value smaller than its default value, and sets upper limit value Wout to a value smaller than its default value, to thereby restrict charging power or discharging power of battery 20. As a result, lithium deposition as well as local overcharging and overdischarging of battery 20 can be avoided. The default value of upper limit value Win and the default value of upper limit value Wout are stored in memory 42.

While ECU 40 performs the calculation process and the estimation process after the external charging in the description of Figs. 5 to 7, ECU 40 may perform the calculation process and the estimation process after the discharging is stopped (after a shutdown of the travel system). In this case, the calculation process corresponds to a process of calculating difference value ΔV02D (Fig. 4), and the estimation process corresponds to a process of estimating the presence or absence of high-rate deterioration based on whether or not difference value ΔV02D is greater than or equal to threshold value TH1.

As described above, according to Embodiment 1, the result of the estimation of the presence or absence of high-rate deterioration is determined in accordance with evaluation value EVV (e.g., difference value ΔV02 or difference value ΔV02D). As a result, the presence or absence of high-rate deterioration can be appropriately estimated.

[Modification 1 of Embodiment 1]

When the SOC is within a predetermined SOC range around 60% (e.g., a range of from 50% or more to 70% or less), the stage structure of the negative electrode of battery 20 changes. In the following description, the range of from 50% or more to 70% or less is also represented as a "first range," and a range different from the first range (e.g., a range of from 10% to 50% or from 80% to 90%) is also represented as a "second range." The inventors found that, in the first range, due to the change in the stage structure, the polarization mitigation behaves significantly differently depending on the presence or absence of high-rate deterioration. Specifically, when the charging-stopped SOC is within the first range, $\Delta V02a$ (Fig. 3) is significantly larger than $\Delta V02b$. This is described in detail below.

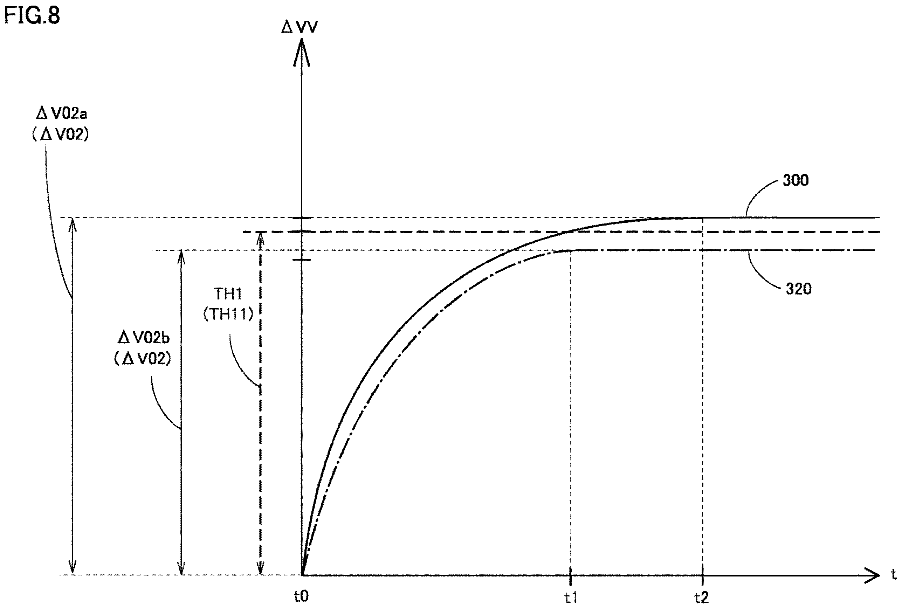

Fig. 8 illustrates how the amount of polarization mitigation varies depending on the presence or absence of high-rate deterioration, when external charging is performed so as to increase the SOC from 10% to 30%. That is, external charging is performed within the second range in this example.

Referring to Fig. 8, the horizontal axis represents time, and the vertical axis represents a change $\Delta VV$ in voltage value VV after time t0. Change $\Delta VV$ corresponds to VV(t0) - VV(t) (VV(t0) = V0). Times t0 to t2, and difference value $\Delta V02$ ($\Delta V02a$ and $\Delta V02b$) are the same as those shown in Fig. 3. In this example, the charging-stopped SOC is 30%, and threshold value TH1 is TH11.

Lines 300 and 320 represent changes $\Delta VV$ in cases A and B, respectively. Lines 300 and 320 are based on lines 200 and 220, respectively.

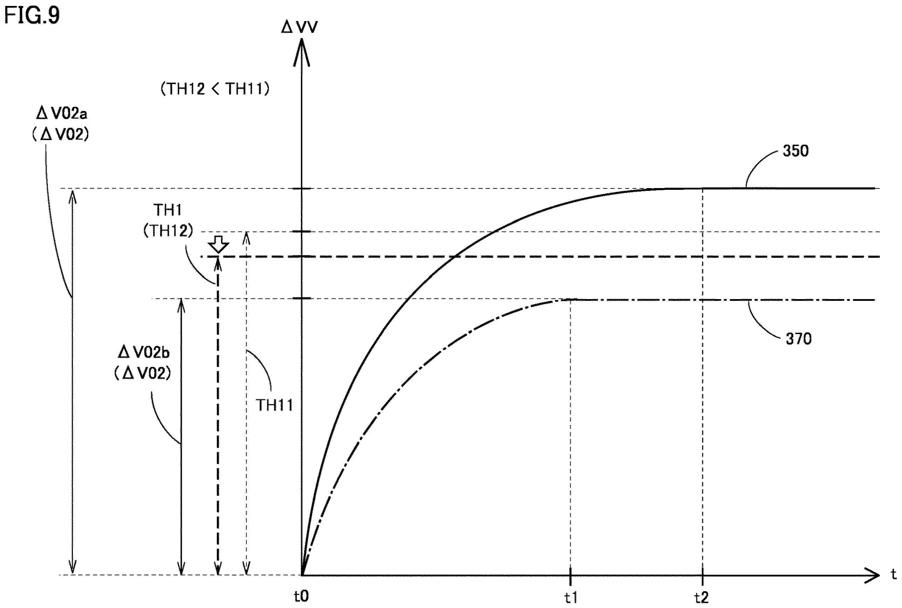

Fig. 9 illustrates how the amount of polarization mitigation varies depending on the presence or absence of high-rate deterioration, when external charging is performed so as to increase the SOC from 50% to 70%. That is, external charging is performed within the first range in this example.

Referring to Fig. 9, this diagram is different from Fig. 8 in that lines 350 and 370 are shown instead of lines 300 and 320. Lines 350 and 370 represent changes $\Delta VV$ in cases A and B, respectively. Lines 350 and 370 are based on lines 200 and 220, respectively. The charging-stopped SOC is 70%.

In this example, unlike the example of Fig. 8, $\Delta V02a$ is significantly larger than $\Delta V02b$ ($\Delta V02a \gg \Delta V02b$). Therefore, ECU 40 can readily estimate the presence or absence of high-rate deterioration in accordance with difference value $\Delta V02$, so long as threshold value TH1 is appropriately set.

In this manner, the polarization mitigation may behave differently depending on the charging-stopped SOC. In order to readily estimate the presence or absence of high-rate deterioration in accordance with difference value $\Delta V02$ (that is, in order for $\Delta V02a$ to be significantly larger than $\Delta V02b$), the charging-stopped SOC is preferably within the first range described above (from 50% to 70%).

In this Modification 1, the stop process described above includes, when a predetermined condition for performing the calculation process and the estimation process is satisfied, stopping the external charging so that the charging-stopped SOC falls within the first range (predetermined SOC range). The predetermined condition is, for example, a lapse of a predetermined time period (e.g., one month) since the last time the estimation process was performed. Information indicating the predetermined time period is stored in memory 42. ECU 40 performs the calculation process and the estimation process after performing the stop process as described above.

According to such a configuration, the external charging is stopped so that the charging-stopped SOC falls within the first range (even when the charging-stopped SOC is set within the second range). This results in forced creation of a situation where the presence or absence of high-rate deterioration can be readily determined. As a result, the presence or absence of high-rate deterioration can be readily estimated in accordance with difference value $\Delta V02$. Therefore, the accuracy of the estimation of the presence or absence of high-rate deterioration can be further improved.

In this example, in order to appropriately estimate the presence or absence of high-rate deterioration, ECU 40 sets threshold value TH1 to TH12, which is lower than threshold value TH1 in the example of Fig. 8 (TH11). Note that it may be preferable for threshold value TH1 to be higher than TH11, since the polarization mitigation may behave differently depending on the characteristics of battery 20 (cells 25). In this case, ECU 40 may set threshold value TH1 to a value higher than TH11. By setting threshold value TH1 when the charging-stopped SOC is within the first range to be different from threshold value TH1 when the charging-stopped SOC is within the second range in this manner, the presence or absence of high-rate deterioration can be appropriately and readily estimated.

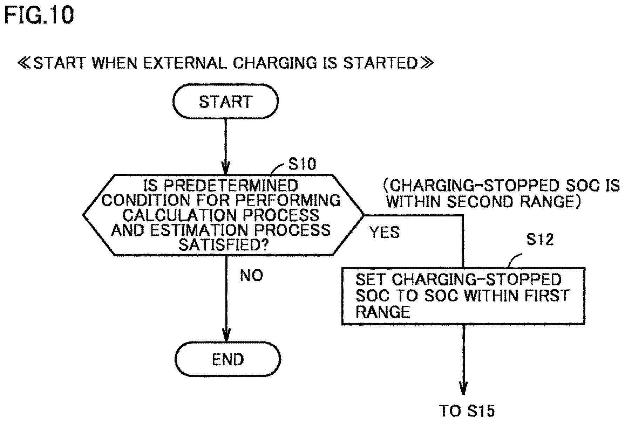

Fig. 10 is a flowchart illustrating the process performed by ECU 40 in Modification 1. This flowchart is different from the flowchart of the embodiment (Fig. 5) in that S10 and S12 are added, but is otherwise the same as the flowchart of Fig. 5.

Referring to Fig. 10, ECU 40 determines whether or not the predetermined condition for performing the calculation process and the estimation process is satisfied (S10). When the predetermined condition is not satisfied (NO in S10), the process ends. When the predetermined condition is satisfied (YES in S10), ECU 40 sets the charging-stopped SOC to an SOC within the first range (e.g., 70%) (S12). In this case, the charging-completed voltage value described above is determined to have a one-to-one correspondence with the set SOC. After S12, the process returns to the process of Fig. 5, and proceeds to S15. ECU 40 then performs the stop process so that the charging-stopped SOC falls within the first range (S30), and performs the calculation process (S50) and the estimation process (S70) after the stop process.

In the above description, the predetermined SOC range described above is an SOC range of from 50% to 70% (first range), and the stop process is a process of stopping the external charging so that the charging-stopped SOC falls within this predetermined SOC range. Such a predetermined SOC range, however, may vary depending on the physical properties of battery 20, and therefore may be predetermined as appropriate based on the physical properties. Thus, the "predetermined SOC range" of the present disclosure is not necessarily limited to the range of from 50% or more to 70% or less, so long as it is predetermined as an SOC range in which the stage structure changes when the SOC falls within this range.

As described above, according to Modification 1, the situation is forcibly created where the presence or absence of high-rate deterioration can be readily determined. As a result, the accuracy of the estimation of the presence or absence of high-rate deterioration can be further improved.

[Modification 2 of Embodiment 1]

Evaluation value EVV is not limited to difference value ΔV02 (ΔV02D). Evaluation value EVV in Modification 2 is described below.

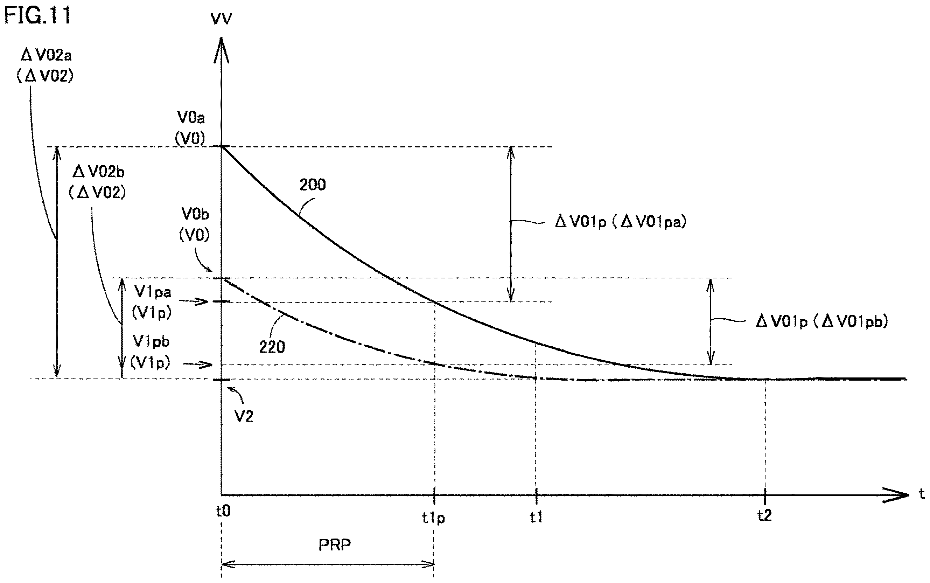

Fig. 11 illustrates an example of evaluation value EVV in Modification 2. Referring to Fig. 11, lines 200 and 220; times t0, t1 and t2; V0 (V0a and V0b) and V2; and difference value ΔV02 (ΔV02a and ΔV02b) are the same as those described in Fig. 3. Note that V2 is an example of "second value" of the present disclosure.

Time tip is a time before time t1, and is an example of "first time" of the present disclosure. At time tip, a predetermined period PRP has elapsed since time t0. Voltage value VV at time tip is also represented as V1p. Note that V1p is an example of "first value" of the present disclosure.

Note that V1p in cases A and B is also represented as V1pa and V1pb, respectively. Note that ΔV01p is a difference value (specifically, its magnitude) between V0 and V1p. Note that ΔV01p in cases A and B is also represented as ΔV01pa and ΔV01pb, respectively. Note that ΔV01pa and ΔV01pb are stored in memory 42 at time tip. In both cases A and B, the polarization mitigation has not yet been completed and is continuing at time tip.

In both cases A and B, ECU 40 calculates, in response to the polarization elimination, a polarization mitigation rate RR, which is the ratio of ΔV01p to difference value ΔV02, as evaluation value EVV. In case A, for example, polarization mitigation rate RR is calculated at time t2 as the ratio of ΔV01pa to ΔV02a. In case B, polarization mitigation rate RR is calculated at time t1 as the ratio of ΔV01pb to ΔV02b. Note that ΔV01p is an example of "first variation" of the present disclosure. Difference value ΔV02 is an example of "second variation" of the present disclosure.

Polarization mitigation rate RR in case A (ΔV01pa/ΔV02a) is lower than polarization mitigation rate RR in case B (ΔV01pb/ΔV02b). This means that the polarization is mitigated more slowly when the high-rate deterioration is present than when the high-rate deterioration is absent.

ECU 40 according to this Modification 2 estimates the presence or absence of high-rate deterioration in accordance with polarization mitigation rate RR at time tip. In this case, the estimation process includes a process of estimating that the high-rate deterioration is absent when polarization mitigation rate RR is greater than or equal to a predetermined second threshold value, and a process of estimating that the high-rate deterioration is present when polarization mitigation rate RR is less than the second threshold value.

The presence or absence of high-rate deterioration is related to whether the polarization is mitigated relatively quickly or relatively slowly. Whether the polarization mitigation is quick or slow is reflected in polarization mitigation rate RR at time tip. When the high-rate deterioration is absent, for example, the polarization has been mostly eliminated at time tip, and therefore, polarization mitigation rate RR at time tip is relatively high. When the high-rate deterioration is present, on the other hand, the polarization has not yet been sufficiently eliminated at time tip, and therefore, polarization mitigation rate RR at time tip is relatively low.

According to the estimation process of Modification 2, the presence or absence of high-rate deterioration is estimated in accordance with polarization mitigation rate RR at time tip. Thus, ECU 40 can appropriately estimate the presence or absence of high-rate deterioration based on whether the polarization mitigation is quick or slow.

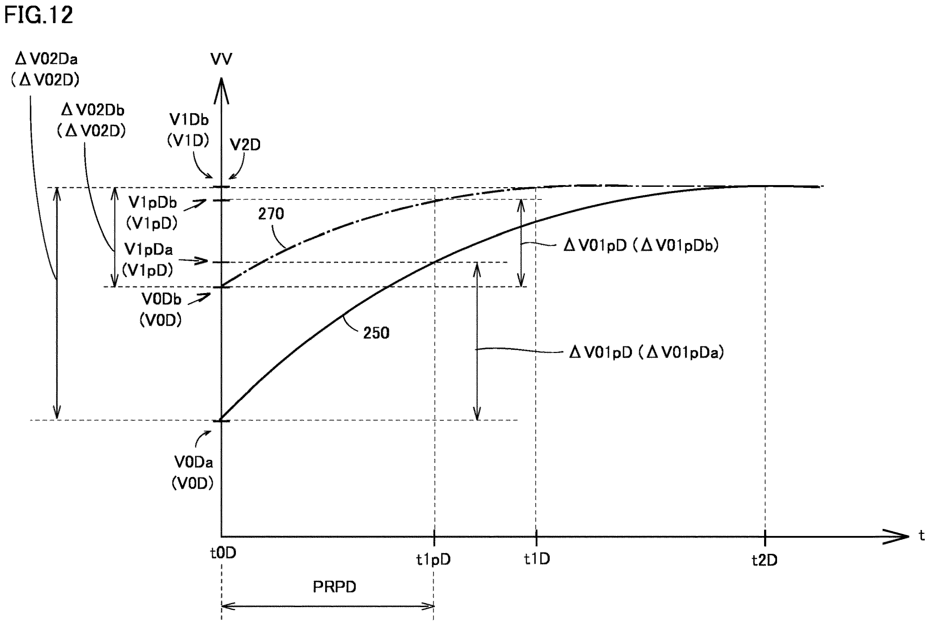

Fig. 12 illustrates another example of evaluation value EVV in Modification 2. Referring to Fig. 12, lines 250 and 270; times t0D, t1D and t2D; V0D (V0Da and V0Db) and V2D; and difference value ΔV02D (ΔV02Da and ΔV02Db) are the same as those described in Fig. 4. Note that V2D is an example of "second value" of the present disclosure.

Time t1pD is a time before time t1D, and is an example of "first time" of the present disclosure. At time t1pD, a predetermined period PRPD has elapsed since time t0. Voltage value VV at time t1pD is also represented as V1pD. Note that V1pD is an example of "first value" of the present disclosure.

Note that V1pD in cases A and B is also represented as V1pDa and V1pDb, respectively. Note that ΔV01pD is a difference value (specifically, its magnitude) between V0D and V1pD. Note that ΔV01pD in cases A and B is also represented as ΔV01pDa and ΔV01pDb, respectively. In cases A and B, ΔV01pDa and ΔV01pDb are stored in memory 42 at time t1pD, respectively. In both cases A and B, the polarization mitigation has not yet been completed and is continuing at time t1pD.

In both cases A and B, ECU 40 calculates, in response to the polarization elimination, polarization mitigation rate RR, which is the ratio of $\Delta V01pD$ to difference value $\Delta V02D$, as evaluation value EVV. In case A, for example, polarization mitigation rate RR is calculated at time t2D as the ratio of $\Delta V01pDa$ to $\Delta V02Da$. In case B, polarization mitigation rate RR is calculated at time t1D as the ratio of $\Delta V01pDb$ to $\Delta V02Db$. Note that $\Delta V01pD$ is an example of "first variation" of the present disclosure. Difference value $\Delta V02D$ is an example of "second variation" of the present disclosure.

Polarization mitigation rate RR in case A ($\Delta V01pDa/\Delta V02Da$) is lower than polarization mitigation rate RR in case B ($\Delta V01pDb/\Delta V02Db$). Again, in this example, the presence or absence of high-rate deterioration is reflected in polarization mitigation rate RR. Therefore, ECU 40 can estimate the presence or absence of high-rate deterioration in accordance with polarization mitigation rate RR, as in the example of Fig. 11.

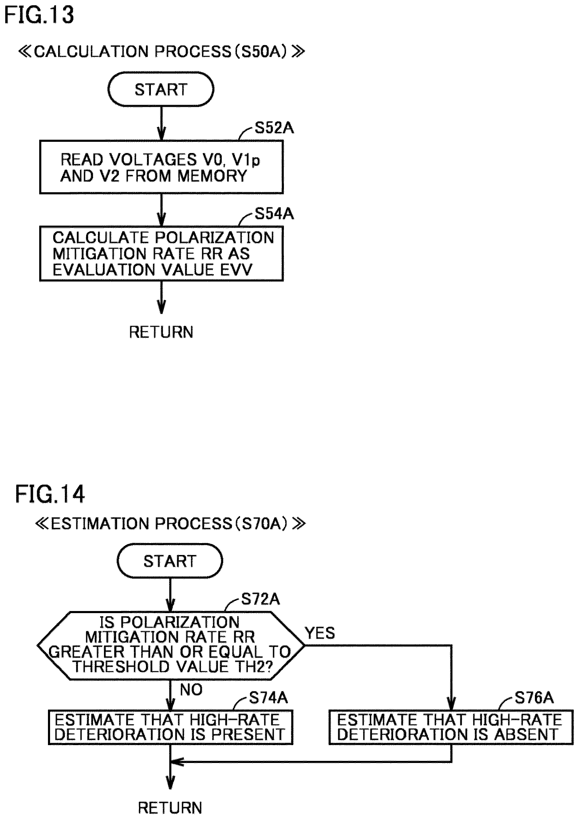

Fig. 13 is a flowchart illustrating a procedure of the calculation process (S50A) in this Modification 2. This flowchart is different from the flowchart of Embodiment 1 (Fig. 6) in that S52A and S54A are performed instead of S52 and S54. Note that S50A is performed instead of S50.

Referring to Fig. 13, ECU 40 reads V0, V1p and V2 from memory 42 (S52A). ECU 40 calculates polarization mitigation rate RR at time tip as evaluation value EVV (S54A). The process then returns to the process of Fig. 5, and proceeds to S70A described below.

Fig. 14 is a flowchart illustrating a procedure of the estimation process (S70A) in this Modification 2. This flowchart is different from the flowchart of Embodiment 1 (Fig. 7) in that S72A, S74A and S76A are performed instead of S72, S74 and S76. Note that S70A is performed instead of S70.

Referring to Fig. 14, ECU 40 determines whether or not polarization mitigation rate RR at time tip is greater than or equal to a threshold value TH2 (which corresponds to the second threshold value described above) (S72A). When polarization mitigation rate RR is greater than or equal to threshold value TH2 (YES in S72A), ECU 40 estimates that the high-rate deterioration is absent (S76A). When polarization mitigation rate RR is less than threshold value TH2 (NO in S72A), ECU 40 estimates that the high-rate deterioration is present (S74A). The process then returns to the process of Fig. 5, and proceeds to S80.

ECU 40 may perform the calculation process and the estimation process after the discharging of battery 20 is stopped. In this case, ECU 40 calculates polarization mitigation rate RR at time t1pD, and estimates the presence or absence of high-rate deterioration in accordance with a result of the calculation.

As described above, ECU 40 may calculate polarization mitigation rate RR at time tip (t1pD) as evaluation value EVV, and estimate the presence or absence of high-rate deterioration in accordance with polarization mitigation rate RR.

[Modification 3 of Embodiment 1]

Evaluation value EVV is not limited to difference value $\Delta V02$ ($\Delta V02D$) and polarization mitigation rate RR. Evaluation value EVV in Modification 3 is described below.

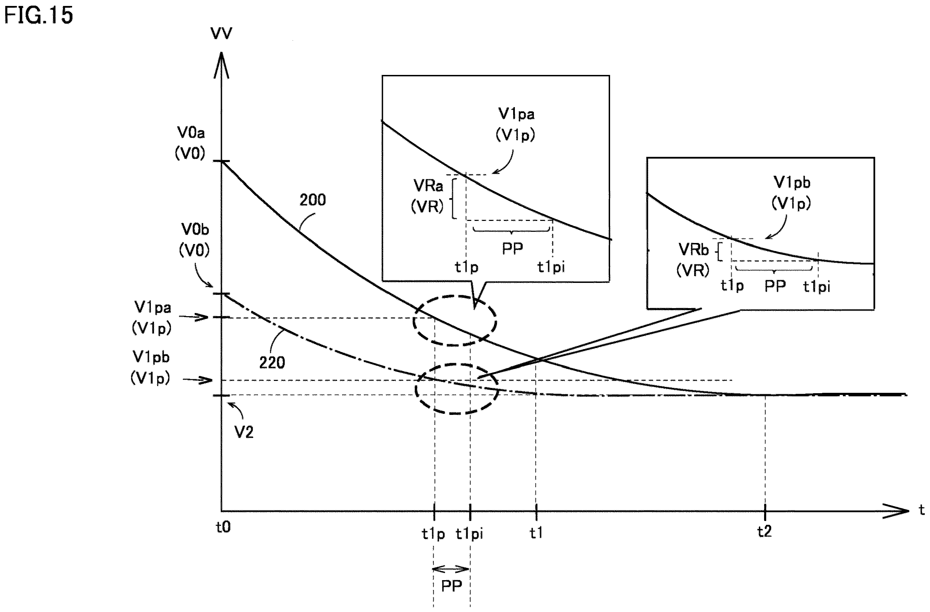

Fig. 15 illustrates an example of evaluation value EVV in Modification 3. Referring to Fig. 15, lines 200 and 220; times t0, t1 and t2; and V0 (VOa and V0b) and V2 are the same as those described in Fig. 3. Time tip is the same as that described in Fig. 11.

Time tipi is a time slightly after time tip and before time t1. A predetermined time period from time tip to time tipi is also represented as a predetermined time period PP. A variation in voltage value VV in predetermined time period PP is also represented as a variation VR. Variation VR is an example of "third variation" of the present disclosure. When predetermined time period PP has a sufficiently short length, variation VR corresponds to a rate of change (derivative) of voltage value VV at time tip. Variations VR in cases A and B are also represented as VRa and VRb, respectively.

Variation VR is higher in case A than in case B (VRa > VRb). This is because the polarization has been mostly eliminated at time tip in case B, whereas the polarization has not yet been sufficiently eliminated at time tip in case A (lines 200 and 220).

ECU 40 estimates the presence or absence of high-rate deterioration in accordance with variation VR. In this case, the estimation process includes a process of estimating that the high-rate deterioration is absent when variation VR is less than a third threshold value, and a process of estimating that the high-rate deterioration is present when variation VR is greater than or equal to the third threshold value.

As mentioned above, the presence or absence of high-rate deterioration is related to whether the polarization is mitigated relatively quickly or relatively slowly. Whether the polarization mitigation is quick or slow is reflected in variation VR. When the high-rate deterioration is absent, for example, the polarization has been mostly eliminated at time tip, and therefore, variation VR is relatively small. When the high-rate deterioration is present, on the other hand, the polarization has not yet been sufficiently eliminated at time tip, and therefore, variation VR is relatively large.

According to the estimation process described above, the presence or absence of high-rate deterioration is estimated in accordance with variation VR. In this case, ECU 40 can immediately calculate variation VR when predetermined time period PP elapses after time tip. Thus, estimating the presence or absence of high-rate deterioration does not necessarily require voltage value VV at the time of polarization elimination (time t1 or time t2). Therefore, even when the user of vehicle 1 starts operation of vehicle 1 without waiting until the polarization is eliminated, ECU 40 can appropriately estimate the presence or absence of high-rate deterioration immediately after predetermined time period PP. As a result, the charging power and the discharging power can be restricted more quickly than in Embodiment 1 and its Modifications 1 to 3. This can allow an early start of protection of battery 20, and improve user convenience.

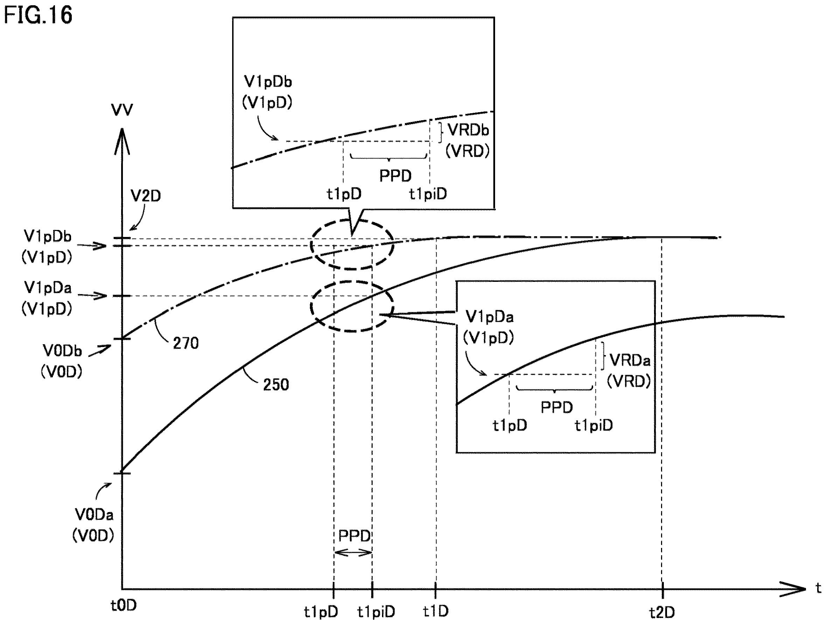

Fig. 16 illustrates another example of evaluation value EVV in Modification 3. Referring to Fig. 16, lines 250 and 270; times t0D, t1D and t2D; and V0D (V0Da and V0Db) and V2D are the same as those described in Fig. 4. Time t1pD is the same as that described in Fig. 12.

Time t1piD is a time slightly after time t1pD and before time t1D. A predetermined time period from time t1pD to time t1piD is also represented as a predetermined time period PPD. A variation in voltage value VV in predetermined time period PPD is also represented as a variation VRD. Variation VRD is an example of "third variation" of the present disclosure. When predetermined time period PPD has a sufficiently short length, variation VRD corresponds to a rate of change in voltage value VV at time t1pD. Variations VRD in cases A and B are also represented as VRDa and VRDb, respectively.

Variation VRD is higher in case A than in case B (VRDa > VRDb). This is because the polarization has been mostly eliminated at time t1pD in case B, whereas the polarization has not yet been sufficiently eliminated at time t1pD in case A (lines 250 and 270).

ECU 40 estimates the presence or absence of high-rate deterioration in accordance with variation VRD. In this case, the estimation process includes a process of estimating that the high-rate deterioration is absent when variation VRD is less than the third threshold value, and a process of estimating that the high-rate deterioration is present when variation VRD is greater than or equal to the third threshold value. According to such an estimation process, ECU 40 can estimate the presence or absence of high-rate deterioration immediately after predetermined time period PPD, as in the example of Fig. 15.

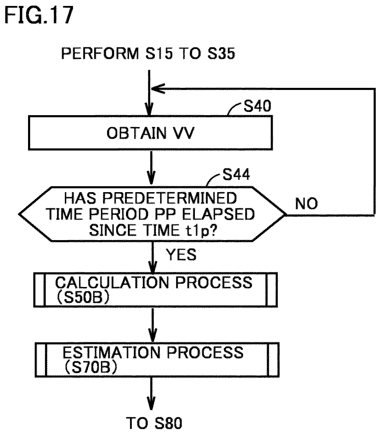

Fig. 17 is a flowchart illustrating the process performed by ECU 40 in this Modification 3. This flowchart is different from the flowchart of the embodiment (Fig. 5) in that S44, S50B and S70B are performed instead of S45, S50 and S70, respectively, but is otherwise the same as the flowchart of Fig. 5.

Referring to Fig. 17, after S15 to S35, ECU 40 determines whether or not predetermined time period PP has elapsed since time tip, that is, whether or not time t1pi has come (S44). When predetermined time period PP has not yet elapsed since time tip (NO in S44), the process returns to S40. When predetermined time period PP has elapsed since time tip (YES in S44), the process proceeds to S50B and S70B.

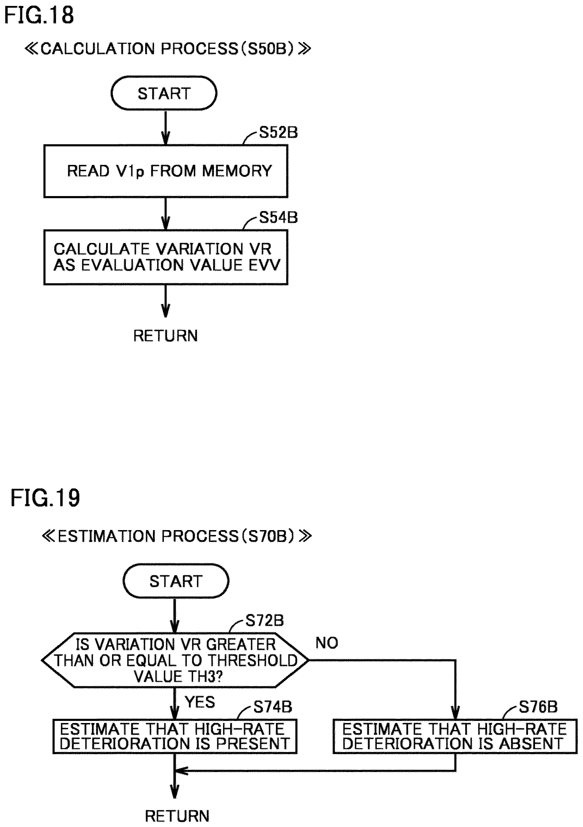

Fig. 18 is a flowchart illustrating a procedure of the calculation process (S50B) in this Modification 3. This flowchart is different from the flowchart of Embodiment 1 (Fig. 6) in that S52B and S54B are performed instead of S52 and S54.

Referring to Fig. 18, ECU 40 reads V1p from memory 42 (S52B), and calculates variation VR as evaluation value EVV (S54B). The process then returns to the process of Fig. 17, and proceeds to S70B.

Fig. 19 is a flowchart illustrating a procedure of the estimation process (S70B) in this Modification 3. This flowchart is different from the flowchart of Embodiment 1 (Fig. 7) in that S72B, S74B and S76B are performed instead of S72, S74 and S76.

Referring to Fig. 19, ECU 40 determines whether or not variation VR is greater than or equal to a threshold value TH3 (which corresponds to the third threshold value described above) (S72B). When variation VR is greater than or equal to threshold value TH3 (YES in S72B), ECU 40 estimates that the high-rate deterioration is present (S74B). When variation VR is less than threshold value TH3 (NO in S72B), ECU 40 estimates that the high-rate deterioration is absent (S76B). The process then returns to the process of Fig. 17, and proceeds to S80.

ECU 40 may perform the calculation process and the estimation process at time t1piD after the discharging of battery 20 is stopped. In this case, ECU 40 calculates variation VRD, and estimates the presence or absence of high-rate deterioration in accordance with a result of the calculation.

As described above, ECU 40 may calculate variation VR (VRD) as evaluation value EVV, and estimate the presence or absence of high-rate deterioration in accordance with variation VR (VRD).

[Modification 4 of Embodiment 1]

Referring again to Figs. 11 and 12, voltage value VV at the time of polarization elimination of battery 20 after the charging or the discharging is stopped (V2 or V2D) may be stored in memory 42 in advance. In this case, voltage value VV at the time of polarization elimination is stored in memory 42 as associated with temperature value TV immediately after the charging or the discharging is stopped (e.g., at time t0 or time t0D).

According to such a configuration, ECU 40 can determine, before the time of polarization elimination (time t1, t2, t1D or t2D), V2 (V2D) in advance in accordance with temperature value TV immediately after the charging or the discharging. As a result, ECU 40 can calculate polarization mitigation rate RR at time tip (t1pD), and thus does not necessarily need to wait until time t2 (t2D). This can therefore improve user convenience, as in Modification 3 of Embodiment 1.

[Modification 5 of Embodiment 1]

In Modifications 2 to 4 of Embodiment 1, voltage value VV when the charging/discharging is stopped (V0 or V0D) varies depending on the presence or absence of high-rate deterioration (e.g., V0a > V0b, or V0Da < V0Db). In contrast, Modification 5 of Embodiment 1 is also applicable to an example where V0 (V0D) is independent of the presence or absence of high-rate deterioration (specifically, where V0a is equal to V0b, or V0Da is equal to V0Db).

[Modification 6 of Embodiment 1]

ECU 40 may perform the calculation process and the estimation process after the external discharging control. That is, "discharging of the secondary battery" of the present disclosure includes both discharging during travel and external discharging.

[Embodiment 2]

How the high-rate deterioration progresses (e.g., on a daily basis) is estimated in accordance with a previous evaluation value EVV (previous evaluation value) calculated at a time point before a current time point by a predetermined time period, and a current evaluation value EVV (current evaluation value) calculated at the current time point. The current time point is also represented as a "first time point," and the time point before the first time point by the predetermined time period is also represented as a "second time point." By comparing the current evaluation value with the previous evaluation value (e.g., calculating the magnitude of a difference value between the current evaluation value and the previous evaluation value), a degree of progress of the high-rate deterioration from the second time point to the first time point can be calculated (monitored). In this manner, the degree of progress is used to monitor the transition of evaluation value EVV.
Evaluation value EVV may vary depending on, in addition to the presence or absence of high-rate deterioration (degree of polarization mitigation), a predetermined parameter that affects the polarization mitigation of battery 20. This parameter is, for example, current IB during charging/discharging or temperature TB. When a current parameter, which is the parameter at the time of calculation of the current evaluation value (first time point), is different from a previous parameter, which is the parameter at the time of calculation of the previous evaluation value (second time point), the result of a comparison between the current evaluation value and the previous evaluation value may be affected by a numerical difference between these parameters. For example, even when the high-rate deterioration has not actually progressed at all from the first time point to the second time point, when current IB during charging/discharging at the first time point is different from current IB during charging/discharging at the second time point, the current evaluation value may be different from the previous evaluation value due to the numerical difference between these currents IB. As a result, it may be erroneously estimated that the high-rate deterioration has progressed from the first time point to the second time point.
In this manner, when the current parameter is different from the previous parameter, the degree of progress of the high-rate deterioration may not be appropriately calculated in accordance with the comparison result described above. In order to appropriately calculate the degree of progress of the high-rate deterioration, therefore, it is preferable to minimize the effect of the numerical difference between the current parameter and the previous parameter.
In Embodiment 2, ECU 40 has features to address the above problem. Specifically, ECU 40 performs a normalization process and a degree-of-progress calculation process. The normalization process corresponds to a process of normalizing at least one of the previous evaluation value and the current evaluation value in accordance with a reference value of the parameter, the current parameter, and the previous parameter. The reference value is stored in memory 42 in advance. The normalization process is performed to reduce the effect of the numerical difference between the previous parameter and the current parameter on the calculation result of the degree of progress of the high-rate deterioration (e.g., to adjust the condition for current IB or temperature TB).
The degree-of-progress calculation process corresponds to a process of estimating, in accordance with a result of the normalization process, the degree of progress of the high-rate deterioration from the second time point to the first time point. Specifically, the degree-of-progress calculation process corresponds to a process of comparing one normalized parameter (which may be either the current parameter or the previous parameter) with the other non-normalized parameter, or comparing the normalized current parameter with the normalized previous parameter, and estimating the degree of progress of the high-rate deterioration in accordance with a result of the comparison.
ECU 40 sets upper limit value Win and upper limit value Wout in accordance with a result of the degree-of-progress calculation process. When the calculated degree of progress is less than a predetermined threshold degree of progress, for example, ECU 40 maintains upper limit value Win and upper limit value Wout at upper limit value Win and upper limit value Wout at the second time point, respectively. When the degree of progress is greater than or equal to the predetermined threshold degree of progress, ECU 40 sets upper limit value Win and upper limit value Wout to be smaller than upper limit value Win and upper limit value Wout at the second time point, respectively. As a result, the charging power and the discharging power is restricted, so that further progress of the high-rate deterioration can be avoided.

According to the normalization process and the degree-of-progress calculation process, the degree of progress is calculated after at least one of the previous parameter and the current parameter has been normalized. This reduces the effect of the numerical difference between these parameters on the calculation result of the degree of progress of the high-rate deterioration. As a result, the degree of progress of the high-rate deterioration can be appropriately calculated.

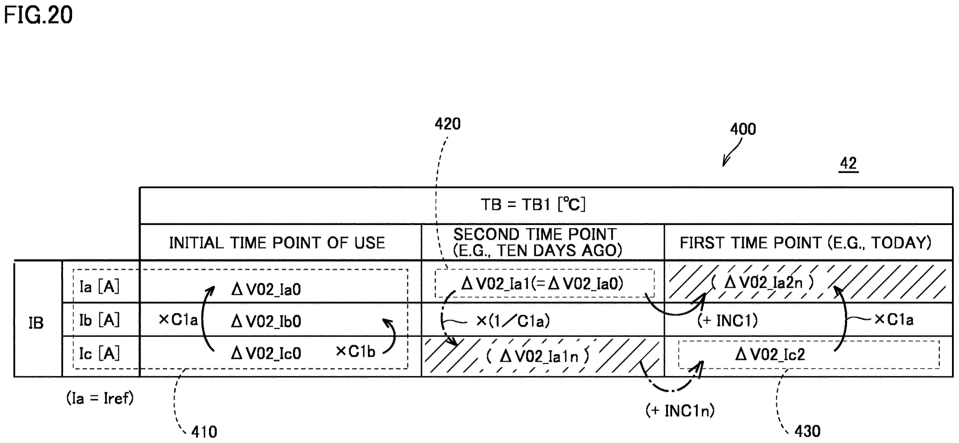

Fig. 20 illustrates an example of data for use in the normalization process in Embodiment 2. Referring to Fig. 20, data 400 is stored in memory 42. In this example, the predetermined parameter that affects the polarization mitigation is current IB during external charging. Current IB during external charging is, in this example, an average of current IB during external charging, but may be current IB immediately before the external charging is stopped, or a current determined in accordance with an amount of IR drop in battery 20 immediately after the external charging is stopped. In this example, evaluation value EVV is difference $\Delta V02$ (Fig. 3).

Data 400 represents difference $\Delta V02$ when current IB is Ia, Ib or Ic, for each of an initial time point of use, a first time point and a second time point (e.g., ten days ago) of battery 20. In each of the initial time point of use, the first time point and the second time point, temperature TB during external charging is TB1. The second time point is after the initial time point of use. Note that Ia is a reference value Iref of current IB in the normalization process. Data 400 includes initial evaluation value information 410, previous evaluation value information 420 and current evaluation value information 430.

Initial evaluation value information 410 includes, for each current IB (current value CV) during external charging, difference $\Delta V02$ calculated in an evaluation test at the initial time point of use. This difference $\Delta V02$ corresponds to an initial evaluation value, which is evaluation value EVV at the initial time point of use. At the initial time point of use, the high-rate deterioration is absent because battery 20 is new and unused.

Initial evaluation value information 410 includes $\Delta V02\_Ia0$, $\Delta V02\_Ib0$ and $\Delta V02\_Ic0$. Note that $\Delta V02\_Ia0$, $\Delta V02\_Ib0$ and $\Delta V02\_Ic0$ correspond to differences $\Delta V02$ when current IB is Ia, Ib and Ic in the evaluation test, respectively. Thus, initial evaluation value information 410 indicates a first relation, which is a correspondence relation between the initial evaluation value and current IB. This relation includes a correspondence relation between the reference evaluation value ($\Delta V02\_Ia0$), which is the initial evaluation value when current IB is Ia (reference value Iref), and Ia. Note that $\Delta V02\_Ia0$ corresponds to a value obtained by multiplying $\Delta V02\_Ic0$ and a coefficient C1a. Note that $\Delta V02\_Ib0$ corresponds to a value obtained by multiplying $\Delta V02\_Ic0$ and a coefficient C1b.

Previous evaluation value information 420 includes difference $\Delta V02$ ($\Delta V02\_Ia1$) as the previous evaluation value calculated at the second time point. Current IB is Ia at the second time point. In this example, $\Delta V02\_Ia1$ is equal to $\Delta V02\_Ia0$. This indicates that the high-rate deterioration is absent at the second time point, as at the initial time point of use. The following description of Embodiment 2 is based on the assumption that the high-rate deterioration is absent at the second time point. In this example, the previous parameter is equal to reference value Iref (Ia).

Current evaluation value information 430 includes difference $\Delta V02$ ($\Delta V02\_Ic2$) as the current evaluation value calculated at the first time point. Current IB is Ic at the time of calculation of $\Delta V02\_Ic2$ (first time point).

Since current IB at the second time point of calculation of the previous evaluation value is Ia, whereas current IB at the first time point of calculation of the current evaluation value is Ic, it is difficult to appropriately calculate the degree of progress of the high-rate deterioration in accordance with a result of a simple comparison between the previous evaluation value and the current evaluation value.

ECU 40 performs a normalization process of normalizing, using the first relation (coefficient C1a), the current evaluation value in accordance with the current parameter (Ic), the previous parameter (Ia) and reference value Iref. Since the previous parameter is equal to reference value Iref in this example, ECU 40 does not need to normalize the previous evaluation value, and normalizes the current evaluation value by multiplying the current evaluation value by coefficient C1a. The previous parameter and the current parameter are stored in memory 42.

The normalized current evaluation value ($\Delta V02\_Ia2n$) is calculated as a value that would be obtained if the current parameter was reference value Iref (Ia). The normalized current evaluation value is larger than the previous evaluation value by an increment INC1. ECU 40 can calculate the degree of progress of the high-rate deterioration from the second time point to the first time point in accordance with increment INC1. ECU 40 may use increment INC1 as the degree of progress, for example.

The reference value may be the current parameter. In this case, the normalization process corresponds to a process of normalizing, using the first relation (coefficient C1a), the previous evaluation value in accordance with the current parameter (Ic), the previous parameter (Ia) and reference value Iref. Specifically, ECU 40 normalizes the previous evaluation value by multiplying the previous evaluation value by an inverse of coefficient C1a. The current evaluation

value ($\Delta V02\_Ic2$) is larger than the normalized previous evaluation value ($\Delta V02\_Ia1n$) by an increment INC1n. ECU 40 may calculate the degree of progress of the high-rate deterioration in accordance with increment INC1n.

As the predetermined parameter that affects the polarization mitigation, temperature TB during external charging (e.g., immediately after external charging) may be used instead of current IB during external charging. In this case, in each of the initial time point of use, the first time point and the second time point, current IB during external charging is the same. Data 400 represents differences $\Delta V02$ depending on temperature TB for each of the initial time point of use, the first time point and the second time point. Initial evaluation value information 410 includes, for each temperature TB (temperature value TV) during external charging, difference $\Delta V02$ calculated in an evaluation test at the initial time point of use. Each of these differences corresponds to the initial evaluation value. ECU 40 performs the normalization process in accordance with: a correspondence relation between the initial evaluation value and temperature TB; temperature TB at the time of calculation of the current evaluation value; temperature TB at the time of calculation of the previous evaluation value; and a reference value of temperature TB, thereby performing the degree-of-progress calculation process.

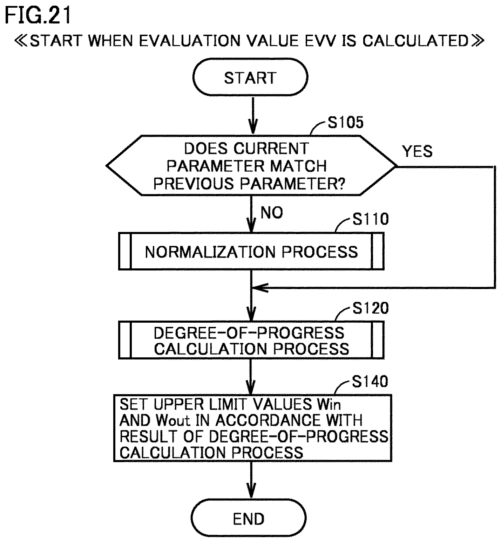

Fig. 21 is a flowchart illustrating the process performed by ECU 40 in Embodiment 2. This flowchart starts when evaluation value EVV (current evaluation value) is calculated at the first time point.

Referring to Fig. 21, ECU 40 determines whether or not the current parameter matches the previous parameter (S105). When the current parameter matches the previous parameter (YES in S105), the process proceeds to the degree-of-progress calculation process (S120). When the current parameter is different from the previous parameter (NO in S105), the process proceeds to the normalization process (S 110) and the degree-of-progress calculation process (S120).

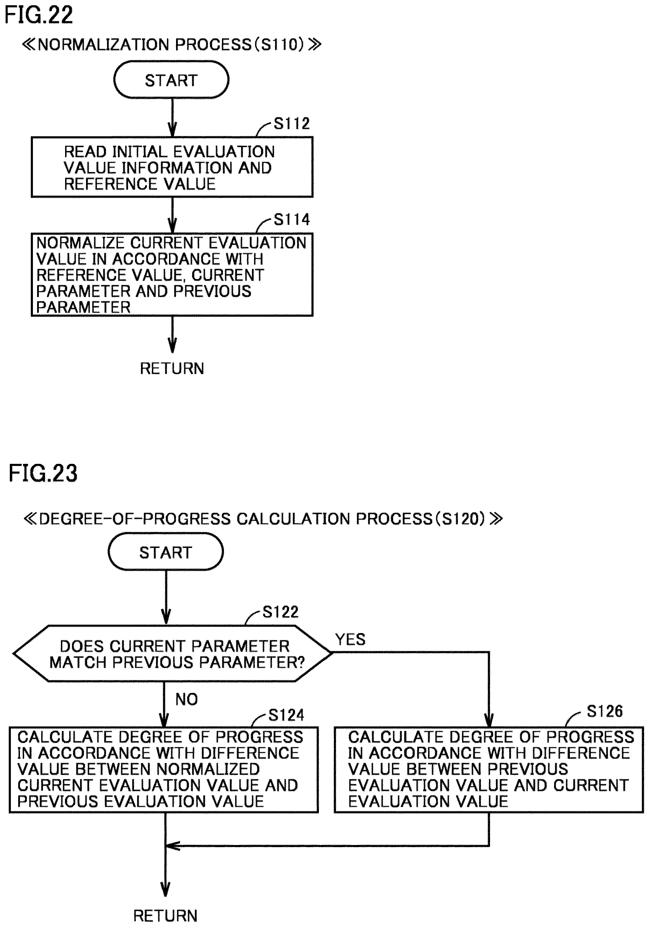

Fig. 22 is a flowchart illustrating a procedure of the normalization process (S110) in detail. Referring to Fig. 22, ECU 40 reads initial evaluation value information 410 (first relation) and reference value Iref of current IB from memory 42 (S112). ECU 40 normalizes, using initial evaluation value information 410, the current evaluation value in accordance with reference value Iref, the current parameter and the previous parameter (S114). The process then returns to the process of Fig. 21, and proceeds to S120.

Fig. 23 is a flowchart illustrating a procedure of the degree-of-progress calculation process (S120) in detail. Referring to Fig. 23, ECU 40 switches the process in accordance with a result of the determination of whether or not the current parameter matches the previous parameter (S105 in Fig. 21) (S122).

When the current parameter is different from the previous parameter (NO in S122), ECU 40 calculates the degree of progress of the high-rate deterioration in accordance with the magnitude of a difference value (e.g., increment INC1 in Fig. 20) between the normalized current evaluation value and the previous evaluation value (S124). When the current parameter matches the previous parameter (YES in S122), ECU 40 calculates the degree of progress in accordance with the magnitude of a difference value between the current evaluation value and the previous evaluation value (S126). The process then returns to the process of Fig. 21, and proceeds to S 140.

Referring again to Fig. 21, ECU 40 sets upper limit value Win and upper limit value Wout in accordance with a result of the degree-of-progress calculation process (S120) (S140).

As described above, according to Embodiment 2, the effect of the numerical difference between the previous parameter and the current parameter on the calculation result of the degree of progress of the high-rate deterioration is reduced. As a result, the degree of progress of the high-rate deterioration can be appropriately calculated. Therefore, further progress of the high-rate deterioration can be appropriately avoided.

[Modification of Embodiment 2]

When the first relation described above is used, the normalization process is based on the assumption that the high-rate deterioration is absent at the second time point ($\Delta V02\_Ia1 = \Delta V02\_Ia0$ in Fig. 20). This modification explains a normalization process that is also applicable to an example where the high-rate deterioration is present at the second time point.

First, ECU 40 estimates the presence or absence of high-rate deterioration at the second time point in accordance with the previous evaluation value. When it is estimated that the high-rate deterioration is present at the second time point, ECU 40 determines the degree of high-rate deterioration at the second time point in accordance with the previous evaluation value, and performs the normalization process in accordance with the degree of high-rate deterioration. The degree of high-rate deterioration is calculated from the following equation (1), as a rate of change (%) that indicates how much a high-rate-deterioration-time evaluation value, which is evaluation value EVV at the time of high-rate deterioration, varies from a corresponding initial evaluation value:

$$(\text{Degree of high-rate deterioration}) = \{[(\text{High-rate-deterioration-time evaluation}$$

$$\text{value}) - (\text{Corresponding initial evaluation value})] / (\text{corresponding initial evaluation}$$

$$\text{value})\} \times 100 \ldots (1)$$

ECU 40 estimates that the high-rate deterioration is present when the degree of high-rate deterioration is nonzero (or greater than or equal to a predetermined threshold degree of deterioration). Otherwise, ECU 40 estimates that the high-rate deterioration is absent.

The corresponding initial evaluation value is an initial evaluation value when current IB at the initial time point of use is current IB at the time of calculation of the high-rate-deterioration-time evaluation value. For example, when current IB at the time of calculation of the high-rate-deterioration-time evaluation value is Ic (Fig. 20), the initial evaluation value ($\Delta$V02_Ic0) corresponding to Ic is the corresponding initial evaluation value.

The degree of high-rate deterioration is calculated based on a certain high-rate-deterioration-time evaluation value (e.g., V02_Icx). ECU 40 calculates the degree of high-rate deterioration by, for example, substituting this certain evaluation value into the high-rate-deterioration-time evaluation value of the equation (1).

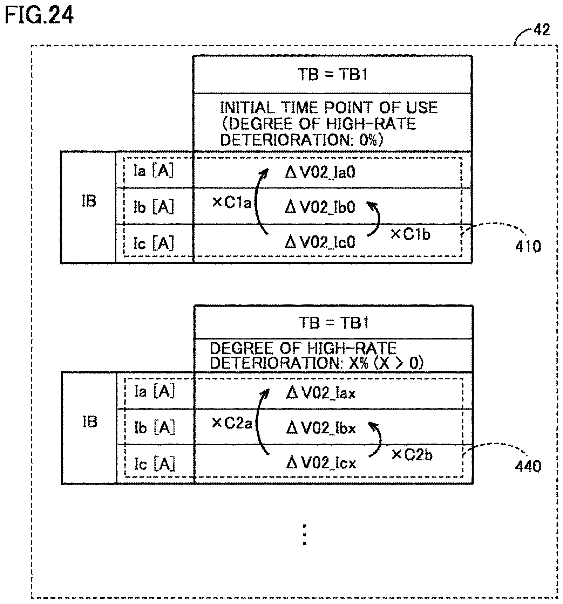

Fig. 24 illustrates an example of data for use in the normalization process in this modification. Referring to Fig. 24, initial evaluation value information 410 and high-rate-deterioration-time evaluation value information 440 are stored in memory 42. Initial evaluation value information 410 is the same as that in Fig. 20. In this example, the predetermined parameter described above is current IB during external charging, but may be temperature TB immediately after external charging.

High-rate-deterioration-time evaluation value information 440 includes AV02_Iax, $\Delta$V02_Ibx and $\Delta$V02_Icx. Note that $\Delta$V02_Iax, $\Delta$V02_Ibx and $\Delta$V02_Icx correspond to differences $\Delta$V02 when current IB is Ia, Ib and Ic in an evaluation test, respectively. This evaluation test is conducted in a situation where the degree of high-rate deterioration is X% (> 0). Each of $\Delta$V02_Iax, $\Delta$V02_Ibx and $\Delta$V02_Icx corresponds to the high-rate-deterioration-time evaluation value in such a situation.

High-rate-deterioration-time evaluation value information 440 indicates a second relation, which is a correspondence relation between the high-rate-deterioration-time evaluation value and current IB. High-rate-deterioration-time evaluation value information 440 is different from initial evaluation value information 410 in that it is associated with the degree of high-rate deterioration. High-rate-deterioration-time evaluation value information 440 indicates how evaluation value EVV varies depending on current IB at the time of high-rate deterioration. Current IB is IB 1 when the evaluation test is conducted in a situation where the degree of high-rate deterioration is X%. Note that $\Delta$V02_Iax corresponds to a value obtained by multiplying $\Delta$V02_Icx and a coefficient C2a. Note that $\Delta$V02_Ibx corresponds to a value obtained by multiplying $\Delta$V02_Icx and a coefficient C2b. Memory 42 may further store, for each current value CV, high-rate-deterioration-time evaluation value information (not shown) on a degree of high-rate deterioration which is different from X%.

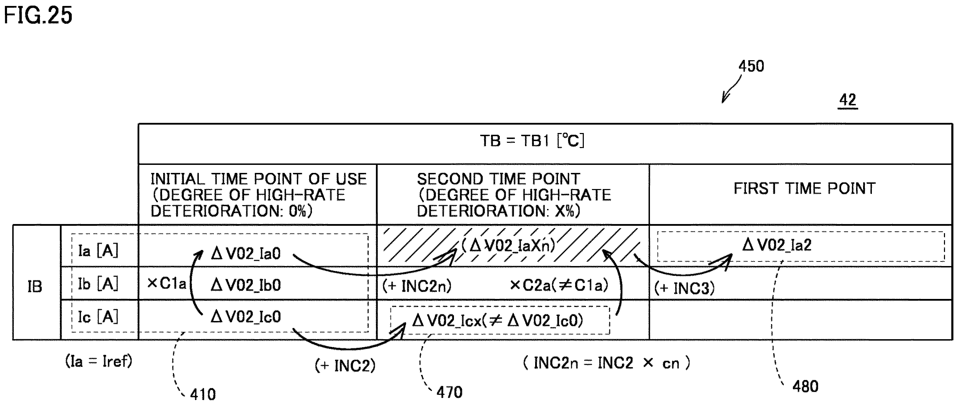

Fig. 25 illustrates the normalization process in this modification. Referring to Fig. 25, data 450 is stored in memory 42. Reference value Iref is Ia, as in the example of Fig. 20. Data 450 includes initial evaluation value information 410, previous evaluation value information 470 and current evaluation value information 480.

Previous evaluation value information 470 includes difference $\Delta$V02 ($\Delta$V02_Icx) as the previous evaluation value calculated at the second time point. Current IB is Ic at the time of calculation of $\Delta$V02_Icx (second time point). Since the degree of high-rate deterioration at the second time point is X%, $\Delta$V02_Icx is larger than $\Delta$V02_Ic0 by an increment INC2. In this example, the previous evaluation value is used as the high-rate-deterioration-time evaluation value corresponding to the second time point.

Current evaluation value information 480 includes difference $\Delta$V02 ($\Delta$V02_Ia2) as the current evaluation value calculated at the first time point. Current IB is Ia at the first time point.

The degree of high-rate deterioration at the second time point is determined from the equation (1), in accordance with the previous evaluation value and the corresponding initial evaluation value, using the previous evaluation value as the high-rate-deterioration-time evaluation value.

ECU 40 estimates the presence or absence of high-rate deterioration at the second time point in accordance with the previous evaluation value, and when it is estimated that the high-rate deterioration is present at the second time point, determines the degree of high-rate deterioration (X%) at the second time point. ECU 40 performs the normalization process in accordance with the determined degree of high-rate deterioration. This normalization process corresponds to a process of normalizing, using the high-rate-deterioration-time evaluation value information associated with the determined degree of high-rate deterioration (e.g., high-rate-deterioration-time evaluation value information 440 (second relation)), the previous evaluation value in accordance with current IB at the second time point and reference value Iref (Ia). The normalization process is a process of multiplying the previous evaluation value by coefficient C2a ($\neq$ C1a).

The normalized previous evaluation value ($\Delta$V02_IaXn) is calculated as a value that would be obtained if current IB at the second time point was reference value Iref. The normalized previous evaluation value is larger than $\Delta$V02_Ia0 by an increment INC2n. Increment INC2n is a value obtained by multiplying increment INC2 and a coefficient cn. In this example, the following equation (2) holds:

$$\Delta V02\_IaXn = (\Delta V02\_Ia0) + (INC2n)$$

$$= (\Delta V02\_Ic0) \times (C1a) + (INC2) \times (cn) \,...\, (2)$$

When performing the degree-of-progress calculation process, ECU 40 can calculate the degree of progress of the high-rate deterioration from the initial time point of use to the second time point in accordance with increment INC2 (or increment INC2n). Likewise, when performing the degree-of-progress calculation process, ECU 40 can calculate the degree of progress of the high-rate deterioration from the second time point to the first time point in accordance with an increment INC3. Increment INC3 is a difference between difference $\Delta$V02 at the first time point ($\Delta$V02_Ia2) and $\Delta$V02_IaXn. By performing the degree-of-progress calculation process in this manner, a process of the progress of the high-rate deterioration can be appropriately monitored.

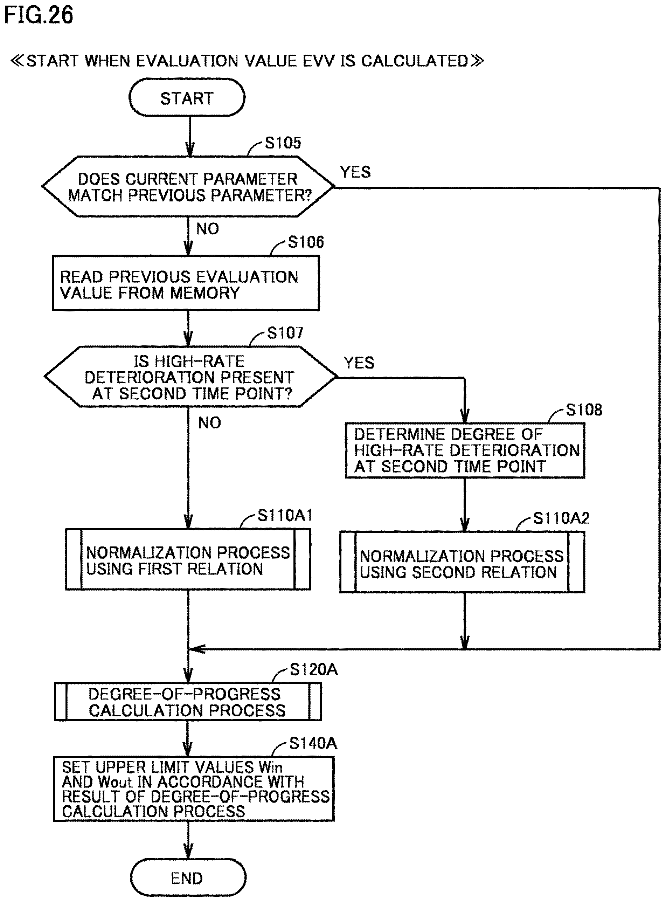

Fig. 26 is a flowchart illustrating the process performed by ECU 40 in this modification. Referring to Fig. 26, this flowchart is different from the flowchart of Embodiment 2 (Fig. 21) in that S106 to S108, S110A1, S110A2, S120A and S140A are performed instead of S110, S120 and S140, but is otherwise the same as the flowchart of Fig. 21.

When the current parameter matches the previous parameter (YES in S105), the process proceeds from S105 to S120A. Otherwise (NO in S105), the process proceeds from S105 to S106.

ECU 40 reads the previous evaluation value from memory 42 (S106), and estimates whether or not the high-rate deterioration is present at the second time point in accordance with the previous evaluation value (S107). When the high-rate deterioration is absent at the second time point (NO in S107), ECU 40 performs the normalization process using the first relation (initial evaluation value information 410) (S110A1). Note that S110A1 is the same as S110 of Embodiment 2 (Fig. 22).

When the high-rate deterioration is present at the second time point (YES in S107), ECU 40 determines the degree of high-rate deterioration at the second time point in accordance with the high-rate-deterioration-time evaluation value and the corresponding initial evaluation value, using the previous evaluation value as the high-rate-deterioration-time evaluation value (S108). ECU 40 performs the normalization process using the second relation associated with the determined degree of high-rate deterioration (S110A2). Specifically, ECU 40 normalizes, using the second relation, the previous evaluation value in accordance with the previous parameter and the reference value (e.g., by multiplying the previous evaluation value by coefficient C2a).

Depending on which one of S110A1 and S110A2 has been performed, ECU 40 performs the degree-of-progress calculation process (S120A). When S110A1 is performed, S120A is the same as S124 (Fig. 23). When S110A2 is performed, S120A corresponds to a process of calculating increment INC2n as the degree of progress at the second time point, and calculating increment INC3 as the degree of progress from the second time point to the first time point. When the current parameter matches the previous parameter (YES in S105), the degree-of-progress calculation process corresponds to a process of calculating the magnitude of a difference value between the previous evaluation value and the current evaluation value as the degree of progress.

ECU 40 sets upper limit value Win and upper limit value Wout in accordance with a result of the degree-of-progress calculation process (S140A). When increment INC3 is greater than or equal to a threshold degree of progress, for example, ECU 40 sets upper limit value Win and upper limit value Wout to be smaller than upper limit value Win and upper limit value Wout at the second time point, respectively.

According to this modification, when the high-rate deterioration is present at the second time point, the previous evaluation value is normalized using high-rate-deterioration-time evaluation value information 440 (second relation) instead of initial evaluation value information 410 (first relation). Thus, the previous evaluation value can be appropriately normalized even in a situation where the high-rate deterioration is present at the second time point. As a result, the degree of progress of the high-rate deterioration from the second time point to the first time point can be more appropriately calculated.

Although the embodiments of the present disclosure have been described, it should be understood that the embodiments disclosed herein are illustrative and non-restrictive in every respect. The scope of the present disclosure is defined by the terms of the claims and is intended to include any modifications within the scope and meaning equivalent to the terms of the claims.

**Claims**

1. A battery system for estimating a presence or absence of deterioration of a secondary battery (20) containing a non-aqueous electrolyte, the deterioration being a phenomenon in which an internal resistance of the secondary battery (20) increases due to uneven ion concentration in the non-aqueous electrolyte, the battery system comprising:

   a voltage sensor (21) that detects a voltage value of the secondary battery (20); and
   a processor (40) configured to perform a calculation process and an estimation process, wherein
   the calculation process includes a process of calculating, in accordance with the voltage value, an evaluation value for evaluating a degree of polarization mitigation after charging or discharging of the secondary battery (20), and
   the estimation process includes a process of estimating the presence or absence of the deterioration in accordance with the evaluation value.

2. The battery system according to claim 1, wherein

   the evaluation value is a magnitude of a difference value between the voltage value when the charging or the discharging is stopped, and the voltage value at time of polarization elimination of the secondary battery (20) after the charging or the discharging is stopped, and
   the estimation process includes

      a process of estimating that the deterioration is absent when the magnitude of the difference value is less than a first threshold value, and
      a process of estimating that the deterioration is present when the magnitude of the difference value is greater than or equal to the first threshold value.

3. The battery system according to claim 2, wherein

   the battery system is mounted on a vehicle (1),
   the vehicle (1) is configured to perform external charging in which the secondary battery (20) is charged with electric power fed from a power facility (5) provided outside the vehicle (1),
   the processor (40) is further configured to perform a stop process of stopping the external charging when an SOC of the secondary battery (20) reaches a charging-stopped SOC during the external charging, or when the voltage value reaches a charging-completed voltage value of the secondary battery (20) corresponding to the charging-stopped SOC,
   the stop process includes, when a predetermined condition for performing the calculation process and the estimation process is satisfied, stopping the external charging so that the charging-stopped SOC falls within a range of from 50% or more to 70% or less, and
   the processor (40) performs the calculation process and the estimation process after the stop process.

4. The battery system according to claim 2, wherein

   the battery system is mounted on a vehicle (1),
   the vehicle (1) is configured to perform external charging in which the secondary battery (20) is charged with electric power fed from a power facility (5) provided outside the vehicle (1),
   a negative electrode material of the secondary battery (20) includes graphite, the processor (40) is further configured to perform a stop process of stopping the external charging when an SOC of the secondary battery (20) reaches a charging-stopped SOC during the external charging, or when the voltage value reaches a charging-completed voltage value of the secondary battery (20) corresponding to the charging-stopped SOC,
   the stop process includes, when a predetermined condition for performing the calculation process and the estimation process is satisfied, stopping the external charging so that the charging-stopped SOC falls within a predetermined SOC range,
   the SOC range is predetermined as an SOC range in which a stage structure of the graphite changes when the SOC falls within this range, and
   the processor (40) performs the calculation process and the estimation process after the stop process.

5. The battery system according to claim 1, wherein

the evaluation value is a polarization mitigation rate, which is a ratio of a first variation to a second variation,

the first variation is a magnitude of a difference between the voltage value when the charging or the discharging is stopped, and a first value, which is the voltage value at a first time after a lapse of a predetermined period since the stop of the charging or the discharging,

the second variation is a magnitude of a difference between the voltage value when the charging or the discharging is stopped, and a second value, which is the voltage value at time of polarization elimination of the secondary battery (20) after the charging or the discharging is stopped, and

the estimation process includes

a process of estimating that the deterioration is absent when the polarization mitigation rate is greater than or equal to a second threshold value, and

a process of estimating that the deterioration is present when the polarization mitigation rate is less than the second threshold value.

6. The battery system according to claim 1, wherein

the evaluation value is a third variation, which is a variation in the voltage value in a predetermined time period after a first time after a lapse of a predetermined period since the stop of the charging or the discharging, and

the estimation process includes

a process of estimating that the deterioration is absent when the third variation is less than a third threshold value, and

a process of estimating that the deterioration is present when the third variation is greater than or equal to the third threshold value.

7. The battery system according to claim 2, wherein

the evaluation value depends on a predetermined parameter that affects the polarization mitigation,

the battery system further comprises a memory (42) that stores a first relation, a previous evaluation value, and a previous parameter,

the first relation being a relation between an initial evaluation value which is the evaluation value at an initial time point of use of the secondary battery (20) and the parameter, the previous evaluation value being the evaluation value at a second time point after the initial time point of use and before a first time point, and the previous parameter being the parameter at time of calculation of the previous evaluation value,

the first relation includes a relation between a reference evaluation value, which is the initial evaluation value when the parameter is a reference value of the parameter, and the reference value,

the processor (40) is further configured to perform a normalization process and a degree-of-progress calculation process,

the normalization process includes a process of normalizing, using the first relation, at least one of the previous evaluation value and a current evaluation value which is the evaluation value at the first time point, in accordance with a current parameter, the previous parameter, and the reference value, the current parameter being the parameter at time of calculation of the current evaluation value, and

the degree-of-progress calculation process includes a process of calculating, in accordance with a result of the normalization process, a degree of progress of the deterioration from the second time point to the first time point.

8. The battery system according to claim 7, wherein

the memory (42) further stores a second relation as associated with a degree of deterioration of the secondary battery (20), the second relation being a relation between a deterioration-time evaluation value which is the evaluation value at time of deterioration of the secondary battery (20) and the parameter,

the degree of deterioration is determined in accordance with the deterioration-time evaluation value, and the initial evaluation value when the parameter at the initial time point of use is the parameter at time of calculation of the deterioration-time evaluation value,

the processor (40)

estimates the presence or absence of the deterioration at the second time point in accordance with the previous evaluation value, and

when it is estimated that the deterioration is present at the second time point, determines the degree of deterioration at the second time point, using the previous evaluation value as the deterioration-time evaluation value, and

the normalization process includes a process of normalizing, using the second relation associated with the degree of deterioration, the previous evaluation value in accordance with the previous parameter and the reference value.

9. The battery system according to claim 7 or 8, wherein
the parameter is a temperature of the secondary battery (20).

10. The battery system according to claim 7 or 8, wherein
the parameter is a charging current or a discharging current of the secondary battery (20).

11. The battery system according to any one of claims 1 to 8, wherein
when it is estimated that the deterioration is present, the processor (40) restricts charging power or discharging power of the secondary battery (20).

12. A method for estimating a presence or absence of deterioration of a secondary battery (20) containing a non-aqueous electrolyte, the deterioration being a phenomenon in which an internal resistance of the secondary battery (20) increases due to uneven ion concentration in the non-aqueous electrolyte, the method comprising:

obtaining (S15) a voltage value of the secondary battery (20) from a voltage sensor (21) that detects the voltage value;
calculating (S50) an evaluation value for evaluating a degree of polarization mitigation after charging or discharging of the secondary battery (20); and
estimating (S70) the presence or absence of the deterioration in accordance with the evaluation value.

FIG.1

FIG.2

EP 4 450 988 A2

FIG.3

EP 4 450 988 A2

FIG.4

# FIG.5

≪START WHEN EXTERNAL CHARGING IS STARTED≫

START

S15
OBTAIN VOLTAGE VALUE VV,
CURRENT VALUE CV AND
TEMPERATURE VALUE TV

S20
CALCULATE SOC

S25
DOES SOC REACH
CHARGING-STOPPED SOC, OR
DOES VV REACH
CHARGING-COMPLETED
VOLTAGE VALUE? — NO

YES

S30
STOP EXTERNAL CHARGING

S35
CALCULATE AVERAGE VALUE
OF CV DURING EXTERNAL
CHARGING

S40
OBTAIN VV

S45
IS POLARIZATION
ELIMINATED? — NO

YES

S50
CALCULATION PROCESS

S70
ESTIMATION PROCESS

S80
SET UPPER LIMIT VALUE Win OF CHARGING
POWER AND UPPER LIMIT VALUE Wout OF
DISCHARGING POWER IN ACCORDANCE WITH
RESULT OF ESTIMATION PROCESS (E.G.,
RESTRICT CHARGING POWER OR
DISCHARGING POWER WHEN HIGH-RATE
DETERIORATION IS PRESENT)

END

FIG.6

≪CALCULATION PROCESS(S50)≫

START

S52

READ V0 FROM MEMORY

S54

CALCULATE DIFFERENCE ΔV02
AS EVALUATION VALUE EVV

RETURN

FIG.7

≪ESTIMATION PROCESS(S70)≫

START

S72

IS DIFFERENCE ΔV02
GREATER THAN OR EQUAL TO
THRESHOLD VALUE TH1?

NO

YES

S74

ESTIMATE THAT HIGH-RATE
DETERIORATION IS PRESENT

S76

ESTIMATE THAT HIGH-RATE
DETERIORATION IS ABSENT

RETURN

FIG.8

EP 4 450 988 A2

FIG.9

EP 4 450 988 A2

FIG.10

≪START WHEN EXTERNAL CHARGING IS STARTED≫

START

S10

IS PREDETERMINED
CONDITION FOR PERFORMING
CALCULATION PROCESS
AND ESTIMATION PROCESS
SATISFIED?

(CHARGING-STOPPED SOC IS
WITHIN SECOND RANGE)

YES

NO

S12

SET CHARGING-STOPPED
SOC TO SOC WITHIN FIRST
RANGE

END

TO S15

FIG.11

FIG.12

# FIG.13

≪CALCULATION PROCESS (S50A) ≫

START

S52A

READ VOLTAGES V0, V1p
AND V2 FROM MEMORY

S54A

CALCULATE POLARIZATION
MITIGATION RATE RR AS
EVALUATION VALUE EVV

RETURN

# FIG.14

≪ESTIMATION PROCESS (S70A) ≫

START

S72A

IS POLARIZATION
MITIGATION RATE RR
GREATER THAN OR EQUAL TO
THRESHOLD VALUE TH2?

YES

NO

S74A

ESTIMATE THAT HIGH-RATE
DETERIORATION IS PRESENT

S76A

ESTIMATE THAT HIGH-RATE
DETERIORATION IS ABSENT

RETURN

FIG.15

FIG.16

FIG.17

PERFORM S15 TO S35

```
                               ┌──S40
        ┌──────────────────────────────────┐
        │          OBTAIN VV               │◄──────┐
        └──────────────────────────────────┘       │
                         │                          │
                         ▼       ┌──S44             │
                    ╱─────────────────────╲         │
                   ╱   HAS PREDETERMINED    ╲   NO   │
                  ╱  TIME PERIOD PP ELAPSED  ╲───────┘
                   ╲     SINCE TIME t1p?    ╱
                    ╲─────────────────────╱
                         │ YES
                         ▼
        ┌──────────────────────────────────┐
        ║   CALCULATION PROCESS            ║
        ║   (S50B)                         ║
        └──────────────────────────────────┘
                         │
                         ▼
        ┌──────────────────────────────────┐
        ║   ESTIMATION PROCESS            ║
        ║   (S70B)                         ║
        └──────────────────────────────────┘
                         │
                         ▼
                      TO S80
```

# FIG.18

《CALCULATION PROCESS (S50B)》

```
        ┌─────────┐
        │  START  │
        └─────────┘
             │
             │        ╱S52B
             ▼
   ┌─────────────────────────┐
   │  READ V1p FROM MEMORY   │
   └─────────────────────────┘
             │
             │        ╱S54B
             ▼
   ┌─────────────────────────┐
   │ CALCULATE VARIATION VR  │
   │ AS EVALUATION VALUE EVV │
   └─────────────────────────┘
             │
             ▼
         RETURN
```

# FIG.19

《ESTIMATION PROCESS (S70B)》

```
              ┌─────────┐
              │  START  │
              └─────────┘
                   │
                   │              ╱S72B
                   ▼
        ╱─────────────────────────╲         NO
       ⟨  IS VARIATION VR GREATER   ⟩───────────────┐
        ⟨ THAN OR EQUAL TO THRESHOLD⟩               │
         ╲      VALUE TH3?         ╱                │
                   │                                │
                   │ YES    ╱S74B                   │         ╱S76B
                   ▼                                ▼
   ┌─────────────────────────────┐   ┌─────────────────────────────┐
   │ ESTIMATE THAT HIGH-RATE     │   │ ESTIMATE THAT HIGH-RATE     │
   │ DETERIORATION IS PRESENT    │   │ DETERIORATION IS ABSENT     │
   └─────────────────────────────┘   └─────────────────────────────┘
                   │                                │
                   │◄───────────────────────────────┘
                   ▼
               RETURN
```

# FIG.20

EP 4 450 988 A2

420   400   42

| | | TB = TB1 [°C] | |
|---|---|---|---|
| | | INITIAL TIME POINT OF USE | SECOND TIME POINT (E.G., TEN DAYS AGO) | FIRST TIME POINT (E.G., TODAY) |
| IB | Ia [A] | $\Delta V02\_Ia0$ | $\Delta V02\_Ia1(=\Delta V02\_Ia0)$ | $(\Delta V02\_Ia2n)$ |
| | Ib [A] | ×C1a  $\Delta V02\_Ib0$ | ×(1/C1a) | (+ INC1)  ×C1a |
| | Ic [A] | $\Delta V02\_Ic0$  ×C1b | $(\Delta V02\_Ia1n)$ | $\Delta V02\_Ic2$ |

(Ia = Iref)

410

(+ INC1n)

430

FIG.21

≪START WHEN EVALUATION VALUE EVV IS CALCULATED≫

START

S105

DOES CURRENT PARAMETER MATCH PREVIOUS PARAMETER? — YES

NO — S110

NORMALIZATION PROCESS

S120

DEGREE-OF-PROGRESS CALCULATION PROCESS

S140

SET UPPER LIMIT VALUES Win AND Wout IN ACCORDANCE WITH RESULT OF DEGREE-OF-PROGRESS CALCULATION PROCESS

END

## FIG.22

≪NORMALIZATION PROCESS (S110)≫

START

S112
READ INITIAL EVALUATION VALUE INFORMATION AND REFERENCE VALUE

S114
NORMALIZE CURRENT EVALUATION VALUE IN ACCORDANCE WITH REFERENCE VALUE, CURRENT PARAMETER AND PREVIOUS PARAMETER

RETURN

## FIG.23

≪DEGREE-OF-PROGRESS CALCULATION PROCESS (S120)≫

START

S122
DOES CURRENT PARAMETER MATCH PREVIOUS PARAMETER?

YES

NO

S124
CALCULATE DEGREE OF PROGRESS IN ACCORDANCE WITH DIFFERENCE VALUE BETWEEN NORMALIZED CURRENT EVALUATION VALUE AND PREVIOUS EVALUATION VALUE

S126
CALCULATE DEGREE OF PROGRESS IN ACCORDANCE WITH DIFFERENCE VALUE BETWEEN PREVIOUS EVALUATION VALUE AND CURRENT EVALUATION VALUE

RETURN

# FIG.24

42

| TB = TB1 | | |
|---|---|---|
| INITIAL TIME POINT OF USE (DEGREE OF HIGH-RATE DETERIORATION: 0%) | | |
| IB | Ia [A] | $\Delta$V02_Ia0 |
| | Ib [A] | ×C1a $\Delta$V02_Ib0 |
| | Ic [A] | $\Delta$V02_Ic0 ×C1b |

410

| TB = TB1 | | |
|---|---|---|
| DEGREE OF HIGH-RATE DETERIORATION: X% (X > 0) | | |
| IB | Ia [A] | $\Delta$V02_Iax |
| | Ib [A] | ×C2a $\Delta$V02_Ibx |
| | Ic [A] | $\Delta$V02_Icx ×C2b |

440

:

## FIG.25

450

42

| IB | | INITIAL TIME POINT OF USE (DEGREE OF HIGH-RATE DETERIORATION: 0%) | SECOND TIME POINT (DEGREE OF HIGH-RATE DETERIORATION: X%) | FIRST TIME POINT |
|---|---|---|---|---|
| | | TB = TB1 [°C] | | |
| | Ia [A] | $\Delta$ V02_Ia0 | ($\Delta$ V02_IaXn) | $\Delta$ V02_Ia2 |
| | Ib [A] | ×C1a   $\Delta$ V02_Ib0 | (+ INC2n)   ×C2a(≠C1a) | (+ INC3) |
| | Ic [A] | $\Delta$ V02_Ic0 | $\Delta$ V02_Icx(≠ $\Delta$ V02_Ic0) | |

(Ia = Iref)

(+ INC2)

( INC2n = INC2 × cn )

410

470

480

# FIG.26

≪START WHEN EVALUATION VALUE EVV IS CALCULATED≫

START

S105

DOES CURRENT PARAMETER MATCH PREVIOUS PARAMETER? — YES

NO

S106

READ PREVIOUS EVALUATION VALUE FROM MEMORY

S107

IS HIGH-RATE DETERIORATION PRESENT AT SECOND TIME POINT? — YES

NO

S108

DETERMINE DEGREE OF HIGH-RATE DETERIORATION AT SECOND TIME POINT

S110A1

NORMALIZATION PROCESS USING FIRST RELATION

S110A2

NORMALIZATION PROCESS USING SECOND RELATION

S120A

DEGREE-OF-PROGRESS CALCULATION PROCESS

S140A

SET UPPER LIMIT VALUES $W_{in}$ AND $W_{out}$ IN ACCORDANCE WITH RESULT OF DEGREE-OF-PROGRESS CALCULATION PROCESS

END

**REFERENCES CITED IN THE DESCRIPTION**

**Patent documents cited in the description**

- JP 2023067271 A
- JP 2017103080 A